# EUROPEAN PATENT SPECIFICATION

(11) **EP 4 468 646 B1**
(45) Date of publication and mention of the grant of the patent: **24.12.2025**
(21) Application number: 23216252.9
(22) Date of filing: 13.12.2023
(51) Int. Cl.: H04L 7/00, G11C 29/02, H03K 5/156, H03L 7/081, G06F 1/10, G11C 7/22, H04L 7/033

(54) **LOW-POWER HIGH-PERFORMANCE CLOCK PATH ARCHITECTURE**
HOCHLEISTUNGS-TAKTPFADARCHITEKTUR MIT GERINGEM STROMVERBRAUCH
ARCHITECTURE DE CHEMIN D'HORLOGE HAUTE PERFORMANCE À FAIBLE PUISSANCE

(30) Priority: 26.05.2023 US 202318324872
(43) Date of publication of application: 27.11.2024
(73) Proprietor: Altera Corporation, San Jose, CA 95134 (US)
(72) Inventor: PERELMAN, Yevgeny, HA 31015 Haifa (IL); TOROKER, Zeev, 2630814 Haifa (IL)
(74) Representative: Viering, Jentschura & Partner mbB Patent- und Rechtsanwälte

(56) References cited:
- US-B1- 10 361 690
- US-B1- 10 560 097
- US-B1- 11 256 286
- US-B1- 9 219 470

## Description

### FIELD

The technical field of the present application is indicated by the appended set of claims. The present application generally relates to a high-speed wireline transmitter.

### BACKGROUND

High-speed wireline transmitters have a data rate of more than 50 Gbps, for example, and typically include circuits for the generation of high-precision clocks signal. Such transmitters can be used in various applications including intra-chip and chip-to-chip transmissions. In one approach, the transmitters are compatible with Ethernet networking technology. However, various challenges are presented in optimizing performance and power consumption.

US 10361690 B1 discloses a first integrated circuit configured to send data to a second integrated circuit, which may perform a duty cycle correction process and/or a skew correction process. For duty cycle correction, a data-in input buffer is enabled to feedback an output clock signal from an output clock node to a duty cycle correction circuit that adjusts a delay of a clock signal received from a delay-locked loop circuit. For skew correction, data-in input buffers are enabled to feedback an output clock signal and an output data signal to adjust delay amounts of delay circuits that adjust delays of clock signals output to clock inputs of output path circuits.

US 10560097 B1 discloses a multiphase serialization system for a voltage-mode transmitter that includes a N-to-one stage driven by a N-phase input clock, a phase alignment unit driven by the N-phase input clock being operated to generated interpolated sampling clock signals by adjusting a plurality of reference clock signals provided to the phase alignment unit based on the N-phase input clock, and a preceding multiplexing stage driven by the interpolated sampling clock signals configured to receive incoming data streams and to output phase aligned data streams to the N-to-one stage.

### SUMMARY

The summary of the invention pursued in the present application is set out in the appended set of claims.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts a table of transmitter performance parameters, in accordance with various embodiments.
FIG. 2 depicts an example clock sensing circuit which uses a different phase sensor for each clock signal for phase alignment of a set of four clock signals, in accordance with various embodiments.
FIG. 3 depicts an example clock sensing circuit which uses a single multiplexed sensor for phase alignment of a set of four clock signals, in accordance with various embodiments.
FIG. 4 depicts an example circuit for adjusting a strobe duty cycle of a clock signal using a duty cycle sensor, in accordance with various embodiments.
FIG. 5 depicts an example data alignment circuit for a clock signal, in accordance with various embodiments.
FIG. 6 depicts an example data alignment circuit for a clock signal which uses split data and driver clocks, in accordance with various embodiments.
FIG. 7A depicts an example D-type flip flop 700 for detecting a phase difference between a data signal, data2, and a clock signal, clk4, in accordance with various embodiments.
FIG. 7B depicts an example timing diagram consistent with FIG. 7A, in accordance with various embodiments.
FIG. 8A depicts a time-interleaved complementary metal-oxide semiconductor (CMOS) stage, in accordance with various embodiments.
FIG. 8B depicts an example timing diagram consistent with FIG. 8A, in accordance with various embodiments.
FIG. 9 depicts an example transmitter 900, in accordance with various embodiments.
FIG. 10A depicts an example of positive phase (PPH) and negative phase (NPH) clock signals, consistent with FIG. 9, in accordance with various embodiments.
FIG. 10B depicts an example of a Pulse Amplitude Modulation 4-level (PAM4) signal output by driver 951 of FIG. 9, in accordance with various embodiments.
FIG. 11A1 depicts an example block diagram of the phase sampler 940 of FIG. 9, in accordance with various embodiments.

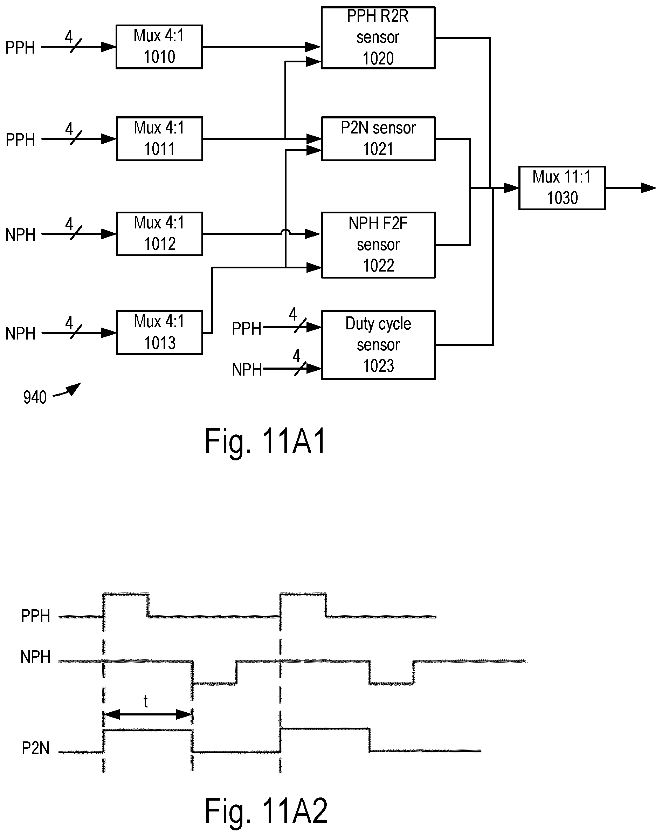

FIG. 11A2 depicts an example timing diagram associated with the P2N sensor 1021 of FIG. 11A1, in accordance with various embodiments.

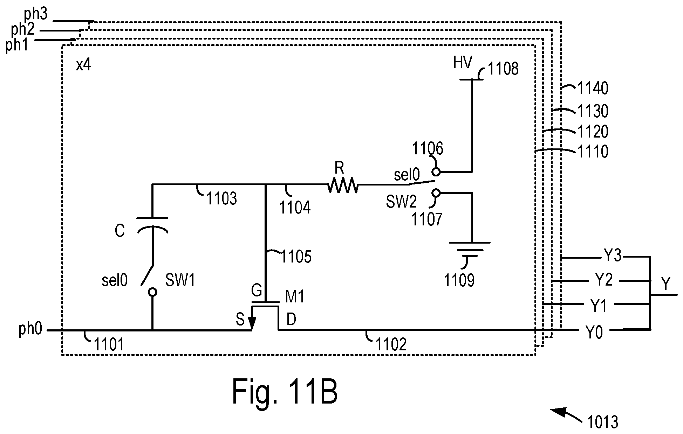

FIG. 11B depicts an example implementation of the multiplexer 1013 of FIG. 11A1, in accordance with various embodiments.

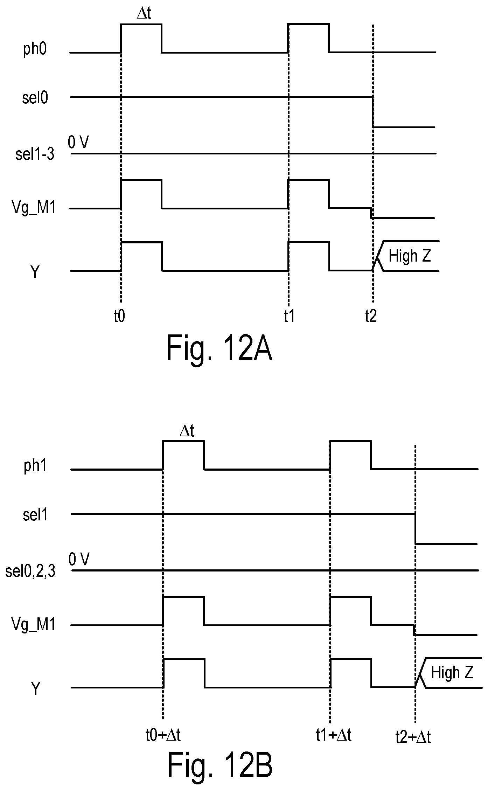

FIG. 12A depicts an example timing diagram consistent with the multiplexer segment 1110 of FIG. 11B, in accordance with various embodiments.
FIG. 12B depicts an example timing diagram consistent with the multiplexer segment 1120 of FIG. 11B, in accordance with various embodiments.

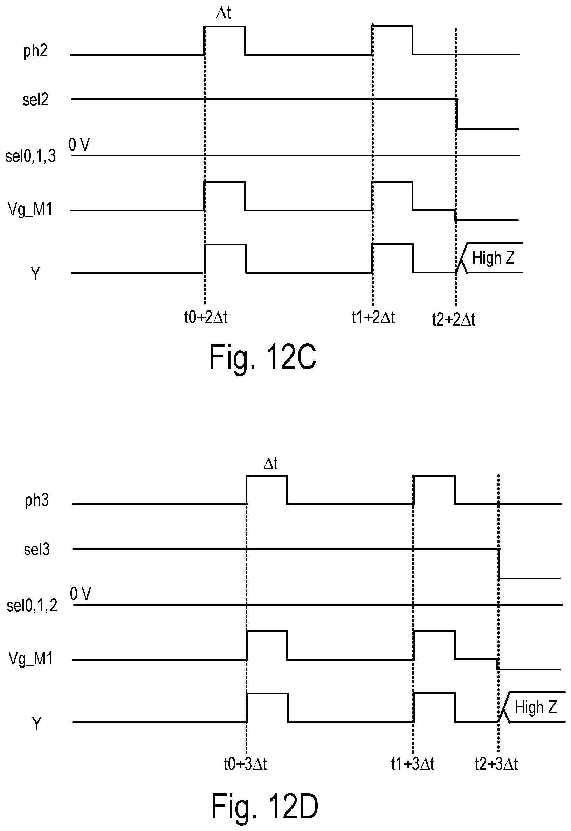

FIG. 12C depicts an example timing diagram consistent with the multiplexer segment 1130 of FIG. 11B, in accordance with various embodiments.
FIG. 12D depicts an example timing diagram consistent with the multiplexer segment 1140 of FIG. 11B, in accordance with various embodiments.

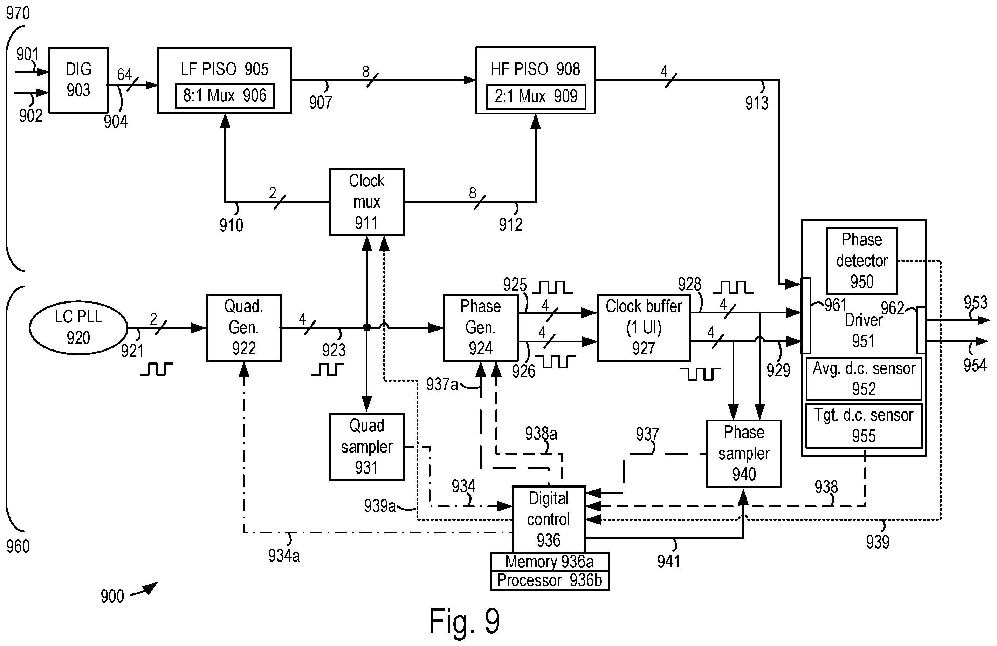

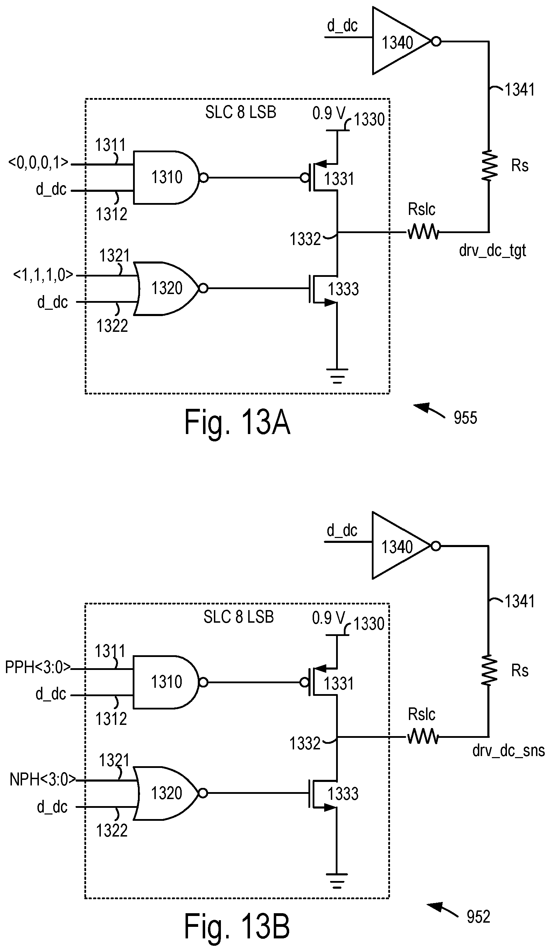

FIG. 13A depicts an example implementation of the target duty cycle sensor 955 of FIG. 9, in accordance with various embodiments.
FIG. 13B depicts an example implementation of the average duty cycle sensor 952 of FIG. 9, in accordance with various embodiments.

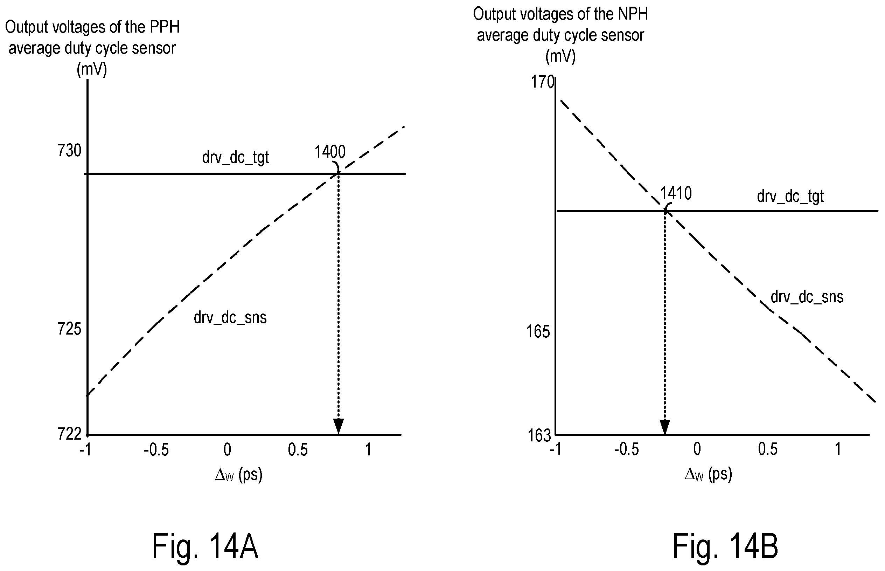

FIG. 14A depicts an example plot of target and sensed output voltages of the positive phase (PPH) average duty cycle sensor 952 of FIG. 13B versus delta pulse width, in accordance with various embodiments.
FIG. 14B depicts an example plot of target and sensed output voltages of the negative phase (NPH) average duty cycle sensor 952 of FIG. 13B versus delta pulse width, in accordance with various embodiments.

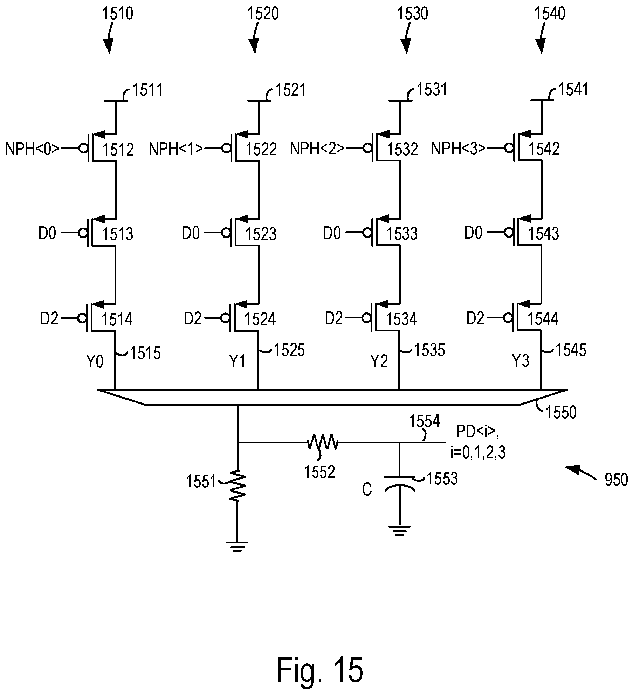

FIG. 15 depicts an example implementation of the phase detector 950 of FIG. 9, in accordance with various embodiments.

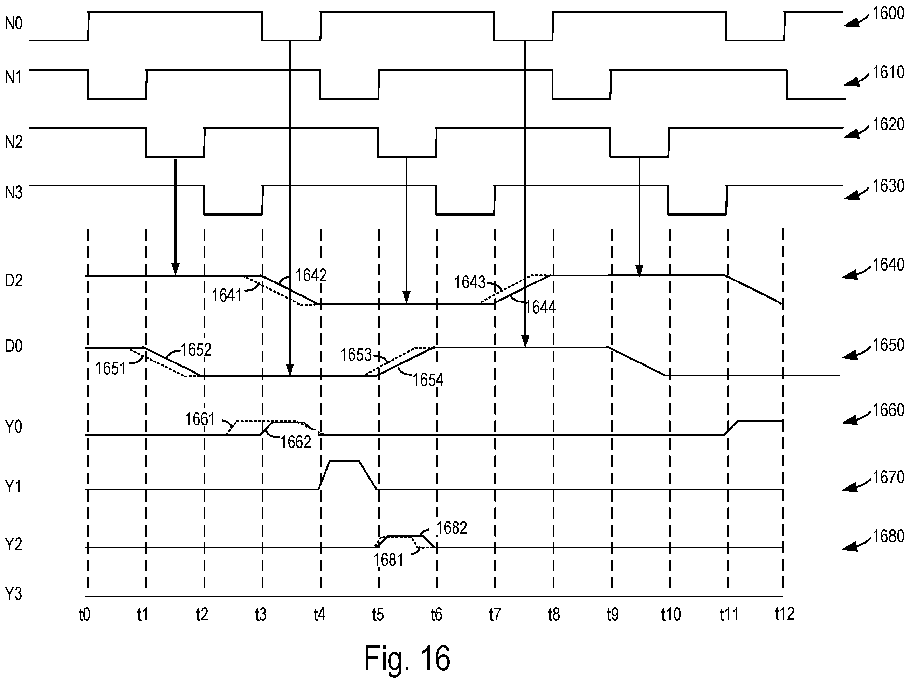

FIG. 16 depicts an example timing diagram consistent with the phase detector 950 of FIG. 15, in accordance with various embodiments.

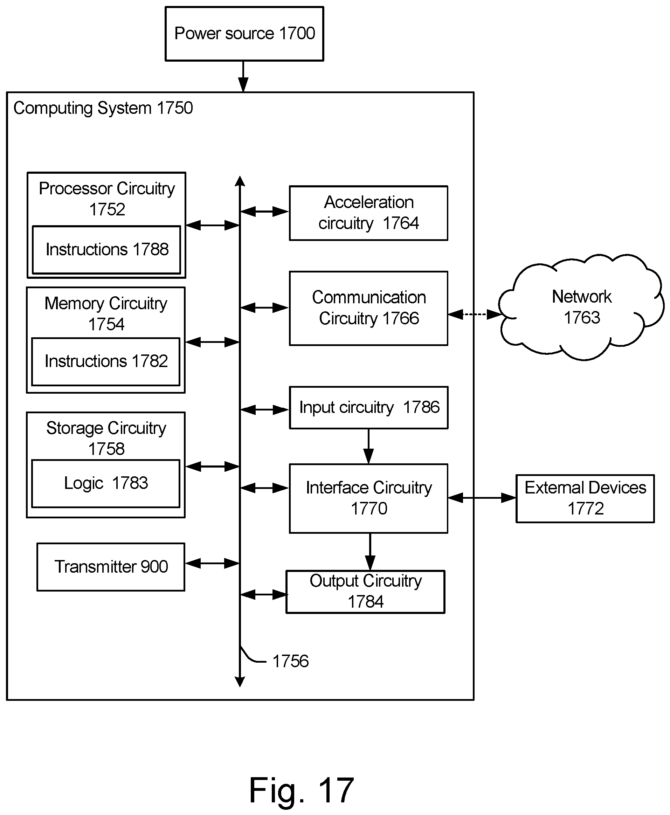

FIG. 17 illustrates an example of components that may be present in a computing system 1750 for implementing the techniques (e.g., operations, processes, methods, and methodologies) described herein.

### DETAILED DESCRIPTION

As mentioned at the outset, various challenges are presented in optimizing performance and power consumption in high-speed wireline transmitters.

High-speed wireline transmitters typically include circuits for the generation of high-precision strobe signals (also referred to as clock signals or clocks). Additionally, an output driver can be provided which usually employs some level of interleaving (4:1 being a common number). To maximize transmitter performance in terms of metrics such as jitter and Signal-to-Noise-and-Distortion Ratio (SNDR), accurate clock alignment is paramount. To achieve good clock alignment, delay elements can be used in different branches of the clock generation system, where an adjustment algorithm controls these delays. The algorithm can base its decisions on a reading of various sensors that assess the accuracy of generated clocks.

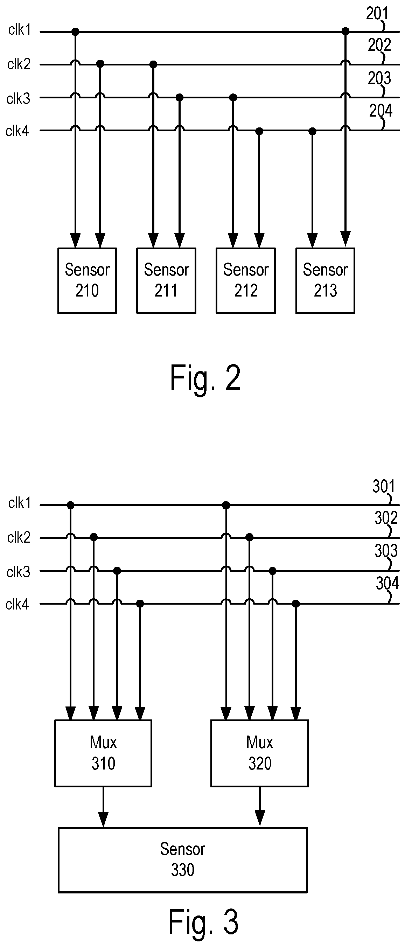

One potential approach to implementing a transmitter involves measuring the mismatch in phase between a pair of clocks on adjacent paths using separate phase sensor circuits. However, this results in a random mismatch between different sensor circuits. See FIG. 2 for further details. As an alternative, one phase sensor with multiplexers is used to measure the mismatch in phase between clocks of each possible pair of clocks. However, this requires a large multiplexer and can result in a power penalty and switching disturbances. See FIG. 3 for further details.

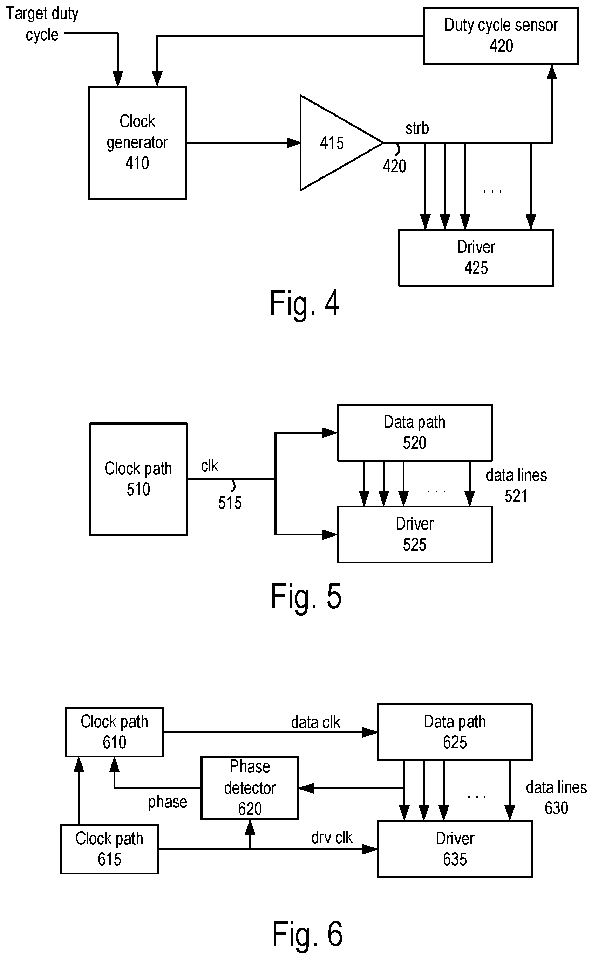

Another possible approach involves using a duty cycle sensor to track strobing signals inside the driver and adjust clock generation to ensure strobe quality. However, adjusting the clock duty cycle to a set value does not consider the process-voltage-temperature (PVT) variations of the driven device. Also, common mode noise can be introduced if the driven devices are of different types, e.g., p- or n-type transistors. See FIGs. 4-6 for further details.

The solutions provided herein address the above and other challenges. In one approach, a clock path architecture for an interleaved transmitter includes a multiplexer (mux.) that allows switching a sensor (e.g., phase sampler circuit) between many pairs of clock signals. As a result, a random mismatch of the sensor does not affect the reading. The mux. can be designed to introduce a relatively small random mismatch, load on the clock tree, and jitter while switching. Additionally, a duty cycle control circuit (e.g., average duty cycle sensor) can provide optimal or otherwise preferred or desirable duty cycle tracking over PVT variations. Setting the duty cycle close to the optimum level improves the jitter and SNDR of the transmitter. Furthermore, a clock-to-data design enables sub-unit interval (UI) alignment of the data stream to the driver clock. Such alignment avoids data corruption over PVT variations at high data rates. Different clocks can also be used in the driver and in the data path, allowing for a significant power reduction of the clocks that are generated in the Clock mux and going to the data path.

These and other features will be further apparent in view of the following discussion.

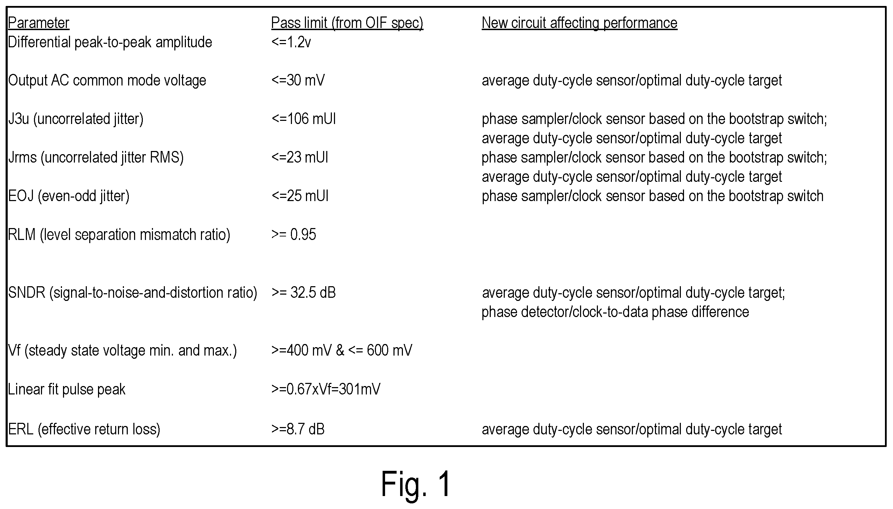

FIG. 1 depicts a table of transmitter performance parameters, in accordance with various embodiments. The parameters are from the Optical Internetworking Forum (OIF), Common Electrical I/O (CEI) - Electrical and Jitter Interoperability agreements for 6G+ bps, 11G+ bps, 25G+ bps, 56G+ bps and 112G+ bps I/O, IA # OIF-CEI-05.0, May 5, 2022. More specifically, the parameters are in the OIF CEI-112G-LR-PAM4 Long Reach Interface, Section 27.3.1. The first column depicts the name of the parameter, the second column depicts the associated pass limit, and the third column depicts the circuits of FIGs. 9-16 which affects the performance. A transmitter circuit (transmitter or TX) described herein has been tested and verified to exceed these performance parameters.

The transmitter circuit includes sensor circuits for clock distribution which enable low-power and high-performance transmission. These circuits include a MUX circuit in a phase sampler for clock sensing based on a bootstrap switch, an average duty cycle sensor that generates an optimal or otherwise preferred or desirable duty-cycle target and measures the averaged duty cycles of clocks for a TX driver, and a phase detector that measures clock-to-data phase differences. These circuits enable power reduction and performance improvements in jitter and SNDR parameters, for example. Details of the circuits are described further below, e.g., in connection with FIGs. 9-16.

A breakdown of the power consumption of the different circuits of the transmitter is as follows: driver 35 mW, clock path 35 mW, data path 23 mW, LDO (low dropout regulator) 1 mW and PLL (phase-locked loop) 10 mW. The total power consumption is 104 mW at 116 Gbps PAM4, resulting in a very high power efficiency of 0.9 pJ/bit. PAM4 denotes Pulse Amplitude Modulation 4-level.

FIG. 2 depicts an example clock sensing circuit that uses a different phase sensor for each clock signal for phase alignment of a set of four clock signals, in accordance with various embodiments. The circuit receives four clock signals, clk1, clk2, clk3, and clk4 on paths 201, 202, 203, and 204, respectively. A first sensor 210 is connected to paths 201 and 202 to receive clk1 and clk2, respectively, and determine a phase difference between them. A second sensor 211 is connected to paths 202 and 203 to receive clk2 and clk3, respectively, and determine a phase difference between them. A third sensor 212 is connected to paths 203 and 204 to receive clk3 and clk4, respectively, and determine a phase difference between them. A fourth sensor 213 is connected to paths 201 and 204 to receive clk1 and clk4, respectively, and determine a phase difference between them.

This is one example implementation of clock sensing which involves measuring the mismatch in phase between a pair of clocks on adjacent paths using separate phase sensor circuit, as mentioned at the outset. Four clock signals are provided as an example and a separate sensor circuit is connected to each pair of consecutive clock signals. However, a drawback of this approach is the random mismatch between different sensor circuits. As the alignment targets become tighter and tighter (e.g., below 100 fSec in a 100 Gbps transmission), sensor circuits with a sufficiently low random mismatch are prohibitively complex or large, overloading the clock distribution network.

FIG. 3 depicts an example clock sensing circuit which uses a single multiplexed sensor for phase alignment of a set of four clock signals, in accordance with various embodiments. The circuit receives four clock signals, clk1, clk2, clk3 and clk4 on paths 301, 302, 303 and 304, respectively. A first multiplexer 310 and a second multiplexer 320 are both connected to each of the paths 301-304, and provide respective outputs to a sensor circuit 330. One clock is provided by each multiplexer at a time so that the sensor can determine the phase difference between any combination of two clock signals.

This is one example implementation of clock sensing which involves using one phase sensor circuit, as mentioned at the outset, switching it between phase pairs. The sensor circuit 330 can represent any of the sensor circuits 210-213 of FIG. 2. The sensor circuit 330 can be connected to different pairs of clock signals using the two 4:1 multiplexers. Since the same sense circuit is used for every one of the four possible pairs, random mismatch of the sensor block does not affect the result. Instead, a random mismatch between different mux. shoulders becomes critical. Since the mux is a relatively simple circuit, the shoulder-to-shoulder random mismatch is easier to manage than the potentially complicated logic of the sensor circuit. Still, for accurate phase alignment, the mux. device size needs to be very large. Shoulder-to-shoulder random mismatch refers to the variation in gain or offset between adjacent channels or inputs.

FIG. 4 depicts an example circuit for adjusting a strobe duty cycle of a clock signal using a duty cycle sensor, in accordance with various embodiments. A clock generator 410 receives a target duty cycle as well as a feedback duty cycle signal from a duty cycle sensor 420. The clock generator 410 outputs a clock signal to a buffer 415, which in turn provides a strobe signal, strb, to the duty cycle sensor and a driver 425. This approach uses the duty cycle sensor to adjust the strobe duty cycle.

High-speed distribution networks often distort strobe/clocks signals. As a result, different kinds of sensors can be employed to track strobing signals inside the driver and adjust the clock generation to ensure strobe quality. One of the parameters which can be tracked is the duty cycle, which can be read by averaging the signal. With an N-to-1 mux., the duty cycle can be adjusted to 1/N, for example. However, the measured duty cycle of the clocks is done just before the clocks enter the driver 425. Inside the driver, the strobe passes through additional gates before sampling the data. Also, the target duty cycle of 1/N is not necessarily the optimal or otherwise preferred or desirable one. For example, in a voltage-mode driver, the pMOS-to-nMOS strength ratio may vary due to PVT variations, moving the optimal duty cycle away from 1/N. pMOS denotes a p-type Metal Oxide Silicon Field Effect Transistor (MOSFET) and nMOS denotes an n-type MOSFET.

FIG. 5 depicts an example data alignment circuit for a clock signal, in accordance with various embodiments. This involves data alignment using a relatively fast (e.g., high frequency) clock. The circuit includes a clock path 510 which outputs a clock, clk, on a path 515 to a data path 520 and a driver 525. The data path provides data to the driver on data lines 521. Generally, data supplied to the driver must be synchronized with driver strobe (clock) signals. One way to achieve alignment is by using driver strobe signals to propagate the data in the data path, so that the data gets aligned implicitly. To achieve such alignment, a latch- or flip-flop-based retimer is used in the last stage of the data path.

The drawback of this solution is the loading presented by the data path on the driver clocks. These clocks directly affect transmission jitter, hence they ought to be of the highest possible quality (high slew-rate signals). Any extra loading on driver clocks results in large power penalties and complicates the design in terms of reliability, power delivery, etc. It is therefore desirable to use different clocks in the data path. Note that multiplexing occurs inside the driver, hence the data path inherently "works" at a much lower frequency compared to the driver, i.e., with 4:1 interleaving, the maximum data path frequency is one-fourth that of the driver. Thus, using a high-frequency clock to propagate low-frequency data is not power efficient.

FIG. 6 depicts an example data alignment circuit for a clock signal which uses split data and driver clocks, in accordance with various embodiments. The circuit includes a clock path 610 which provides a data clock to a data path 625, and a clock path 615 which provides a drive (drv) clock to the clock path 610 and a driver 635. The data path 625 provides data to the driver on the data lines 630 and to a phase detector 620.

The data clock must be aligned with the driver clock. This can be done at phase detector 620 by measuring the phase of data signals in the driver with respect to the driver clock and delaying the data clock so that synchronization is achieved. This approach requires no latch-based retimer and also relaxing the clock jitter requirement in the data clk, resulting in significant power savings.

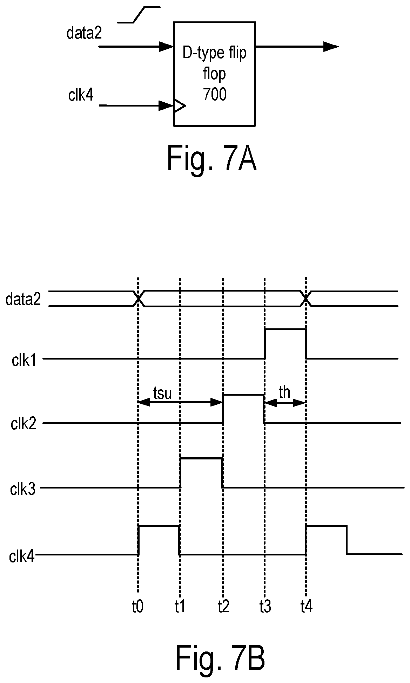

FIG. 7A depicts an example D-type flip flop 700 for detecting a phase difference between a data signal, data2, and a clock signal, clk4, in accordance with various embodiments. One way of detecting data alignment is by sampling the data signal with a rising edge of the driver clock signal using the D-type flip flop. By considering only those samples occurring on the rise of the data signal and aligning the data so that half of the samples will be "0" and half will be "1", the rise of the data signal will be aligned to a rise in the clock signal. An example of such alignment with four clock phases is shown in FIG. 7B.

FIG. 7B depicts an example timing diagram consistent with FIG. 7A, in accordance with various embodiments. The waveforms include data2, which can transition from high to low and back to high, or from low to high and back to low, at time points t0 and t4. clk1 is high from t3 to t4, clk2 is high from t2 to t3, clk3 is high from t1 to t2, and clk4 is high from t0 to t1. The setup time (tsu) is 2 UI, from t0 to t2, and the hold time (th), from t3 to t4, is 1 UI. This could be reversed so that the setup time is 1 UI and the hold time is 2 UI. The UI, or unit interval, is the pulse time or symbol duration time. It may be the minimum amount of time required to transmit one bit of digital data. Since the data is aligned to one of the clock edges, the granularity of alignment is 1 UI.

The approaches described above in connection with FIGs. 2 to 7B have several disadvantages. For example, regarding the sensor multiplexer solutions of FIGs. 2 and 3, the phase alignment mechanism usually requires a very large multiplexer, either a tri-state based or pass-gate-based, that connects pairs of clock phases to a common sensor circuit. The size is mainly defined by the random mismatch between neighboring mux. shoulders. There are two issues caused by the large mux. The first issue is an excessive load on the fast clock, which incurs a power penalty. The second issue is a switching event. Specifically, while the mux. is switched from one pair of clock phases to the next pair, a short disturbance on the clock lines may be introduced, due to the switching of a large capacitive load. This has the potential of causing single-error events in transmitter operation. Moreover, such events can occur repeatedly during clock adaptation.

Regarding the previously mentioned averaged duty cycle sensor approach such as in FIG. 4, adjusting the clock duty cycle to a set value does not consider the PVT variations of the driven device. For example, in a 116 Gbps PAM4 implementation, an MOS device can easily exhibit a 150mV over-corner threshold voltage shift. With a strobe rising time of 7pSec/750mV, this corresponds to almost 3pSec modulation of the activity period, considering a MOS device "active" while Vgs > Vth. With a symbol rate of 58 Gbps, this is almost 20% of the unit interval. Moreover, the threshold voltage can easily shift by another 100mV over an operating temperature range of -40 to +100 C.

An additional problem arises if the driven devices are of different types (i.e., P/N), as discussed next.

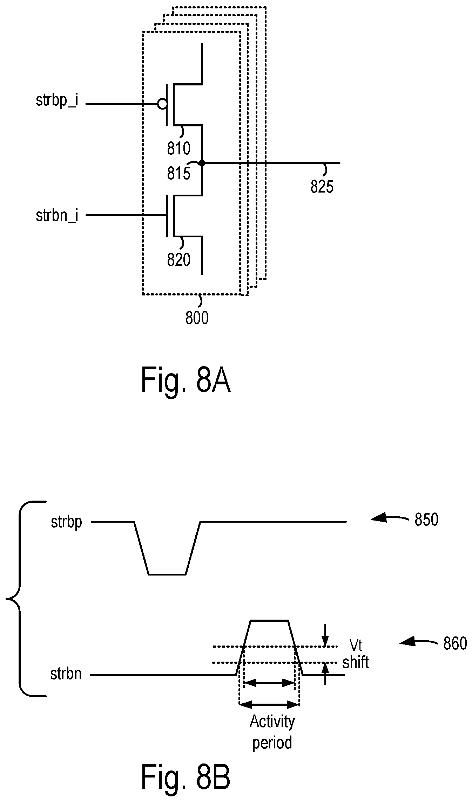

FIG. 8A depicts a time-interleaved CMOS stage, in accordance with various embodiments. The CMOS stage 800 includes a pMOS transistor 810 in series with an nMOS transistor 820. An output path 825 is connected to a midpoint 815 between the two transistors. The control gate of the pMOS transistor receives a voltage strbp_i and the control gate of the nMOS transistor receives a voltage strbn_i, where _i denotes the ith stage.

FIG. 8B depicts an example timing diagram consistent with FIG. 8A, in accordance with various embodiments. In particular, the waveforms 850 and 860 represent strbp and strbn, respectively. In this case, not only the output pulse shape is affected, but also common-mode noise is introduced, as different devices experience different excursions of threshold voltage (Vt), both over process corners and temperature. For example, the activity period can shift from a relatively short period when the Vth is relatively high, to a relatively long period when the Vth is relatively low.

Regarding the previously mentioned phase detector approach such as in FIG. 6, the intention behind separating the data path from the driver clocks is to allow as "sloppy" a data path as possible, thus saving power. For example, the data path could even be powered by a low-voltage noisy digital supply. To make this possible, the margin for data signal jitter should be maximized. An alignment granularity of 1 UI may not be the best option, as it may be desired to place the driver clock phase exactly in the middle of the stable period of the respective data phase. For example, see FIG. 7B, where clk2 is in the middle of data 2. Hence, it might be favorable to align the phases with a finer step size, especially as the data rate increases (and the UI time decreases).

FIG. 9 depicts an example transmitter 900, in accordance with various embodiments. The TX and clock path architecture are discussed first. Further below, details of a bootstrap nMOS switch-based sensor mux., average duty-cycle sensor and clock-to-data phase detector are provided.

The transmitter can be conceptually divided into clock path 960 and data path 970. In the clock path source, an inductor-capacitor (LC) PLL 920 generates a differential 4-UI clock on path 921 for use by a quadrature (quad.) generator (gen) 922. The two clocks comprise a pair of signals with opposite polarities, and in phase with one another, where the difference between the two signals represents the data being transmitted.

In one possible implementation, in the highest baud rate (e.g., 116 Gbps), the clock frequency is 14.5GHz (UI=17.2pSec). The quadrature generator 922 may generate four phases (1 UI-spaced) with a duty cycle of 50% on path 923. That is, four clock signals with four respective phases are generated. Generally, an N-phase clock, where N≥1, refers to N separate clock signals on N respective paths, e.g., wires. Regarding the 1 UI spacing, this refers to the phase difference between the clocks. The clocks on path 923 are provided to a clock multiplexer 911 and a quadrature sampler 931. The quad sampler 931 determines phase errors in the input clock signals and, in response, provides an output on path 934 to a digital control circuit 936. In response to the output, the digital control circuit provides a control signal on path 934a to adjust the quad. generator. The digital control can include a processor 936b which is to execute instructions stored in a memory 936a.

The clock multiplexer 911 provides 8-UI, 50% duty cycle clocks to a low-frequency parallel-in, serial-out circuit (LF PISO) 905 via a path 910 and to a high-frequency PISO (HF PISO) 908 via a path 912. Circuits 905 and 908 may be shift registers, for example. In particular, two clocks are provided to the LF PISO and eight clocks with a phase difference of about 1 U are provided to the HF PISO. The clock multiplexer 911 can delay the clocks to provide alignment between the HF PISO and driver 951. As indicated by its name, the operating frequency of the LF PISO is lower than that of the HF PISO. The driver comprises digital-to-analog converters in multiple sub-blocks or slices.

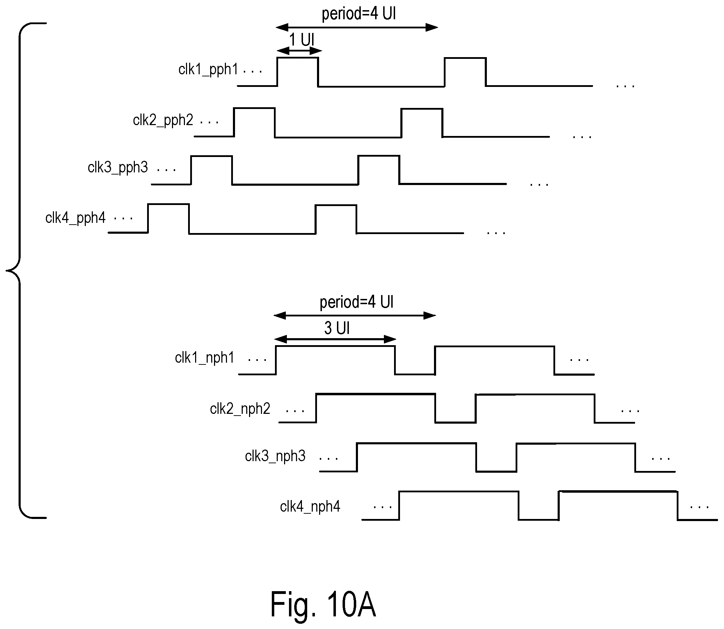

A phase generator 924 generates two sets of 4-UI phases, for a total of eight clocks. Each set includes four 1-UI spaced clocks. There are four positive phase (PPH) clocks on path 925 having a duty cycle of ~25% (1 UI) and four negative phase (NPH) clocks on path 926 having a duty cycle of ~75% (3 UI). A clock has a positive or negative phase relative to another clock when it leads or lags, respectively, the other clock. See also FIG. 10A.

A clock buffer 927 includes a set of buffers for distributing the PPH and NPH clocks from the phase generator to driver 951 via paths 928 and 929, respectively. The driver receives the data signals from the data path and the clock signals from the clock path at the input node 961. A phase sampler 940 is coupled to paths 928 and 929 to compare the phases of the clocks and provide a corresponding output to a digital control circuit 936 on path 937. The digital control circuit, in response, provides a control signal to adjust the phases to the phase generator 924 on path 937a. The digital control circuit also provides a control signal (e.g., sel0 in FIG. 11B) on path 941 to switches SW1 and SW2 in mux. segments of the phase sampler. See also FIG. 11B.

A clock-to-data phase detector 950, average duty cycle sensor 952, and target duty cycle sensor 955 are placed inside the driver 951. The phase detector 950 detects phase differences between the data signal on path 913 and the clock signals on paths 928 and 929, and provides a corresponding output to a digital control circuit 936 on path 939. The digital control circuit, in response, provides a control signal to adjust the clock mux. 911 on path 939a.

The average duty cycle sensor 952 and target duty cycle sensor each provide sensed and target duty cycle values, respectively, for the PPH and NPH clocks (separately). See also FIG. 13A and 13B. During PPH/NPH calibration, phases within the set are distributed evenly with 1-UI spacing and the duty cycle is set to their target values. The average duty cycle sensor 952 provides a corresponding output (indicating an error in the duty cycle) to the digital control circuit 936 on path 938. The digital control circuit, in response, provides a control signal to adjust the phase generator 924 on path 938a.

The data path source includes a digital (DIG) circuit/module 903 that receives a parallel data stream on paths 901 and 902 and applies feed-forward equalization (FFE). A 7-bit digital-to-analog converter (DAC) and 8-tap FFE may be used, for example. The digital (DIG) circuit/module 903 can be a digital data source. The example transmitter uses PAM4 coding in which every two bits represents one of four coding levels, e.g., 00, 01, 11, or 10. DIG generates a 64x7 bit word for every 64 transmitted symbols on path 904, in an example implementation. The 64x7 bit word is multiplexed into 8x7 bit words in the LF PISO at an 8:1 mux. 906 and output on path 907. The HF PISO further multiplexes the 8x7 bit words into 4x7 bit words at a 2:1 mux. 909 and output on path 913 to driver 951. A mux-based PISO advantageously consumes much less power compared to shift-register or FF-based serialization.

The clock-to-data phase detector (placed inside the driver) measures the skew of the data signal relative to the PPH (or NPH) clock. An adjustment algorithm tunes the delay of the clock mux. 911 so that the skew is set around 1.5 UI, for example. This eliminates the requirement for retiming latches at the output of the HF PISO.

The driver 951 provides for the final 4:1 multiplexing, converting 4x7 bit words into four symbols, differentially driven via an output node 962, and paths 953 and 954 onto output pads through an output network. The driver in the example is a 7-bit digital-to-analog converter, for example. In general, the DAC can be of any size and it depends on the output word from the DIG block.

In sum, the transmitter 900 has a number of advantageous features including a bootstrapped switch-based clock sensor multiplexers in the phase sampler 940 allowing for small device size yet with a small random mismatch, a driver 951 slice to generate optimal duty cycle targets for driver clocks, and an analog clock-to-data phase detector 950 allowing for sub-UI data alignment.

Advantages include the use of multiplexers in the phase sampler. This provides a power reduction by reducing the loading presented by the sensor on the clock network, as well as relaxation of single-event jitter introduced by sensor switching.

Another advantage is an optimal duty cycle target. This improves jitter and SNDR as well as output driver common-mode noise reduction.

Another advantage is the clock-to-data phase detector with sub-UI alignment accuracy and a larger data alignment margin. This reduces the risk of data misalignment over PVT variations and reduces power through a lower supply voltage in the data path.

FIG. 10A depicts an example of PPH and NPH clock signals, consistent with FIG. 9, in accordance with various embodiments. An example of the PPH clocks includes clk_pph1, clk2_pph, clk3_pph and clk4_pph, where clk2_pph leads clk1_pph by 1 UI, clk3_pph leads clk2_pph by 1 UI, and clk4_pph leads clk3_pph by 1 UI. An example of the NPH clocks includes clk_nph1, clk2_nph, clk3_nph and clk4_nph, where clk2_nph lags clk1_nph by 1 UI, clk3_nph lags clk2_nph by 1 UI, and clk4_nph lags clk3_nph by 1 UI. In some cases, clk_pph1 is the same as clk_nph1.

The clock period of both the PPH and NPH is 4 UI. In the PPH, the positive pulse width is 1 UI (duty cycle of 25%) but in the NPH the positive pulse width is 3 UI (duty cycle of 75%). The skew between phases (rise to rise edges for example) after calibration is 1 UI.

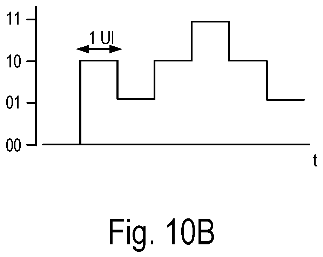

FIG. 10B depicts an example of a PAM4 signal output by driver 951 of FIG. 9, in accordance with various embodiments. The PAM4 signal can have one of four levels where each level represents two bits of data. This example includes bits 00, 10, 01, 10, 11, 10, and 01. PAM4 is one example of an analog multi-level signal which can be output from the transmitter 900. Each symbol has a width of 1 UI.

FIG. 11A1 depicts an example block diagram of the phase sampler 940 of FIG. 9, in accordance with various embodiments. The phase sampler provides the following types of readings. The first type of reading is the duty cycle for every phase. The second type of reading is PPH-to-NPH alignment, e.g., the alignment of a PPH clock to an NPH clock. The third type of reading is an alignment within the PPH (e.g., PPH R2R), which measures the spacing between PPH rising edges. R2R denotes rising edge-to-rising edge. The fourth type of reading is an alignment within the NPH (e.g., NPH F2F), which measures the spacing between NPH falling edges. F2F denotes falling edge-to-falling edge.

The phase sampler includes a set of multiplexers 1010-1013 which receive, at their inputs, clock signals from the paths 928 and 929 in the clock path 960 of the transmitter, and a set of phase sensors 1020-1022 coupled to outputs of the set of multiplexers.

Input 4:1 multiplexers 1010, 1011, 1012 and 1013 can be used to select pairs of phases (clocks with different phases). In particular, the multiplexers 1010 and 1011 both receive the four PPH clock signals on path 928, and multiplexers 1012 and 1013 both receive the four NPH clock signals on path 929. Each mux selects one of the clocks signals at a time and provides it at its output to one of the sensors. Each sensor receives two clock signals at a time and compares their phase to determine a phase difference. Once the comparison is done for one pair of clock signals, the next pair of clock signals can be selected until all combinations of clock signals have been compared. The sensors can communicate the phase difference to the digital control 936 for use in adjusting the timing of the phase generator 924.

The sensors include a PPH R2R sensor 1020, a P2N sensor 1021, and an NPH F2F sensor 1022. In particular, the PPH R2R sensor receives the PPH clock outputs of the multiplexers 1010 and 1011 and determines a phase difference between them based on a time difference between their rising edges. The P2N sensor receives the PPH and NPH outputs of the multiplexers 1011 and 1013, respectively. P2N denotes positive to negative. The NPH F2F sensor receives the NPH outputs of the multiplexers 1012 and 1013 and determines a phase difference between them based on a time difference between their falling edges. The duty cycle sensor 1023 also receives the PPH and NPH clocks. The duty cycle sensor 1023 is just an RC filter while the average duty cycle sensor 952 comprises active device as depicted in FIG. 13B.

The outputs of the sensors 1020-1023 are multiplexed at an 11:1 output mux. 1030 to output a DC analog signal from the phase sampler 940 to the digital control circuit 936 for use in adjusting the phase generator 924. The DC analog signal is provided to a 1-bit ADC (comparator and Vref), the output of which is provided to the digital control.

An example implementation of one of the multiplexers 1010 to 1013 is discussed next. The multiplexors may have the same configuration.

FIG. 11A2 depicts an example timing diagram associated with the P2N sensor 1021 of FIG. 11A1, in accordance with various embodiments. The timing diagram depicts the inputs to the P2N sensor, PPH and NPH, and the output, P2N. P2N transitions high when PPH transitions high, and transitions low when NPH transitions low. The time t represents the time between these transitions. The P2N sensor can be used when the time difference between the phases is of the order of 2 UI. When the PPH phase is exactly 2UI different from the NPH phase, the output of the gate is a clock signal with duty-cycle of 50%.

FIG. 11B depicts an example implementation of the multiplexer 1013 of FIG. 11A1, in accordance with various embodiments. The multiplexer includes four segments 1110, 1120, 1130 and 1140, which receive clock signals ph0, ph1, ph2 and ph3, respectively, and output signals Y0, Y1, Y2 and Y3, respectively. A single output Y is provided as the pre-segment outputs Y0, Y1, Y2, and Y3 are shorted to a single wire. This provides a 4-to-1 mux, with 4 clocks inputs 4 select controls, and a single output Y. For the multiplexers 1010 and 1011, ph0, ph1, ph2 and ph3 can represent the PPH clock signals. For the multiplexers 1012 and 1013, ph0, ph1, ph2 and ph3 can represent the NPH clock signals. Segment 1110 is depicted in detail.

The 4:1 multiplexer 1013 is based on a bootstrapped nMOS switch (transistor M1). Each mux. segment comprises switches (SW1 and SW2), a capacitor C, and a resistor R. The clock signal ph0 is input on path 1101, which is coupled to the first switch SW1 and to the source (S) of the nMOS transistor M1. Path 1101 is the input path for one of the clock signals. The drain (D) of the nMOS transistor is coupled on the output path 1102 to provide the output signal Y.

SW1 is in series with the capacitor C in path 1103 and controlled by a first select signal sel0, e.g., from the digital control circuit 936. Path 1103 is in parallel with a control gate path 1105 coupled to the control gate (G) of M1. These two paths in turn are coupled to path 1104 which includes the resistor R. Path 1104 is coupled to the second switch SW2 which is also controlled by sel0. In a first position, SW2 connects path 1104 to node 1106 and a high voltage at power supply node 1108. In a second position, SW2 connects path 1104 to a node 1107 and a ground voltage at a ground node 1109.

The nMOS transistor M1 is bootstrapped in that a voltage on its control gate can be increased by a voltage stored on the capacitor. The path 1101 is coupled to the path 1102 when M1 is turned on (conductive), in which case Y0=ph0, e.g., either a high or low (0 V) voltage. M1 is turned on when SW2 couples the paths 1104 and 1105 to the power supply node. M1 is turned off (non-conductive) when SW2 couples the paths 1104 and 1105 to the ground. In this case, path 1102 has a floating voltage and a high impedance (Z).

When SW1 is closed (conductive), the bottom side of the capacitor is coupled to path 1101. When SW1 is open (non-conductive), the bottom side of the capacitor has a floating voltage.

Segments 1120, 1130, and 1140 can have a similar configuration as the segment 1110 except their switches will be controlled by control signals sel1, sel2, and sel3, respectively.

FIGs. 12A to 12D show example timing diagrams of the multiplexer segments 1110, 1120, 1130, and 1140, respectively. As noted, there is a single output Y from the multiplexer.

FIG. 12A depicts an example timing diagram consistent with the multiplexer segment 1110 of FIG. 11B, in accordance with various embodiments. This segment is active when sel0 is high. ph0 goes high at t0 and t1 for a period Δt(1). sel0 goes low at t2. sel1-3 are low, at 0 V, throughout the time when segment 1110 is selected, indicating the associated segments are inactive. Vg_M1, the control gate voltage of M1, which is also the voltage on tpath 1105, follows ph0 by going high at t0 and t1 for the period Δt. Vg_M1 drops slightly at t2 when sel0 transitions lower. Y follows ph0 by going high at t0 and t1 for the period Δt, then transitions to a high Z state when sel0 transitions lower and the segment becomes inactive.

When sel0=1, SW1 is closed and SW2 is connected to the high voltage supply (HV) in the multiplexer segment 1110. The level of HV should be chosen so that Vgs(M1) is as high as possible (i.e., around 1 V in this example) but sufficiently small to avoid electrical overstress (EOS) on transistor M1. Note that the HV value depends upon the duty cycle and the levels of ph0, hence NPH and PPH sensors will use different HV levels. A MOS device with a high Vgs is less sensitive to Vth variations (the dominant source of device mismatch). A "regular" (i.e., complementary metal-oxide semiconductor (CMOS) or tri-state) mux. would have its devices transiting between conductive and cut-off states during the rise/fall of ph0, meaning that most of the time, the devices have a low Vgs (and are therefore sensitive to Vth variations).

When sel0=0, Vg(M1)=0, hence the output is at a high impedance. The mux. may have a small kick-back during switching due to the relatively small device size and the long transition time of the gate voltage. Vg_M1 drops slightly at t2 because when sel0=0 SW2 is connected to the ground, there is a path between Vg_M1 to the ground. When sel0=1, Vgs of M1 is nearly constant and it is determined by the voltage difference of the capacitor (close to about 1V).

FIG. 12B depicts an example timing diagram consistent with the multiplexer segment 1120 of FIG. 11B, in accordance with various embodiments. This segment is active when sel1 is high. ph1 goes high at t0+Δt and t1+Δt for a period Δt. sel1 goes low at t2+Δt. sel0,2,3 are low, at 0 V, throughout the time when the segment 1120 is selected. Vg_M1 follows ph1 by going high at t0+Δt and t1+Δt for the period Δt. Vg_M1 drops slightly at t2+Δt when sel1 transitions lower. Y follows ph1 by going high at t0+Δt and t1+Δt for the period Δt, then transitions to a high Z state when sel1 transitions lower. When sel1=1, SW1 is closed and SW2 is connected to high voltage supply (HV) in the multiplexer segment 1120.

FIG. 12C depicts an example timing diagram consistent with the multiplexer segment 1130 of FIG. 11B, in accordance with various embodiments. This segment is active when sel2 is high. ph2 goes high at t0+2Δt and t1+2Δt for a period Δt. sel2 goes low at t2+2Δt. sel0,1,3 are low, at 0 V, throughout the time when the segment 1130 is selected. Vg_M1 follows ph2 by going high at t0+2Δt and t1+2Δt for the period Δt. Vg_M1 drops slightly at t2+2Δt when sel2 transitions lower. Y follows ph2 by going high at t0+2Δt and t1+2Δt for the period 2Δt, then transitions to a high Z state when sel2 transitions lower. When sel2=1, SW1 is closed and SW2 is connected to high voltage supply (HV) in the multiplexer segment 1130.

FIG. 12D depicts an example timing diagram consistent with the multiplexer segment 1140 of FIG. 11B, in accordance with various embodiments. This segment is active when sel3 is high. ph3 goes high at t0+3Δt and t1+3Δt for the period Δt. sel3 goes low at t2+3Δt. sel0,1,2 are low, at 0 V, throughout the time when the segment 1140 is selected. Vg_M1 follows ph3 by going high at t0+3Δt and t1+3Δt for the period Δt. Vg_M1 drops slightly at t2+3Δt when sel3 transitions lower. Y follows ph3 by going high at t0+3Δt and t1+3Δt for the period 3Δt, then transitions to a high Z state when sel3 transitions lower. When sel3=1, SW1 is closed and SW2 is connected to high voltage supply (HV) in the multiplexer segment 1140.

FIG. 13A depicts an example implementation of a target duty cycle sensor 955 of FIG. 9, in accordance with various embodiments. The sensor 955 includes a NAND gate 1310 which receives <0,0,0,1> on a first input path 1311 and d_dc on a second input path 1312. A NOR gate 1320 receives <1,1,1,0> on a first input path 1321 and d_dc on a second input path 1322. <0,0,0,1> and <1,1,1,0> are logic inputs to the 4 bit bus. Four instance of the block/sensor 955 shown can be connected in parallel. d_dc is set in the digital control 936.

An output of the NAND gate is provided to the control gate of an pMOS transistor 1331, while an output of the NOR gate is provided to the control gate of a nMOS transistor 1333. The pMOS and nMOS transistors are coupled in a series path that includes a power supply node 1330 at, e.g., 0.9 V, a midpoint 1332 between the transistors and a ground. A path 1341 is coupled to the midpoint 1332 via resistors Rslc and Rs, and carries the target value, drv_dc_tgt. The path is also coupled to an inverter 1340 which receives d_dc as an input.

In FIG. 13A, the drv_dc_tgt value of NPH is obtained when d_dc='1' and the drv_dc_tgt value of PPH is obtained when d_dc='0'. The optimum delta pulse width is being tracked all the time the transmitter is working since it can be affected by temperature and supply variations during operation. Not only this sensor is being used like that to track temperature and supply variations but also all sensors in the phase sampler block 940 and the phase detector 950. The temperature variations can changes in a timescale of milliseconds or microseconds, for example.

FIG. 13B depicts an example implementation of the average duty cycle sensor 952 of FIG. 9, in accordance with various embodiments. The sensor has the same construction as the sensor in FIG. 13A but uses different signals. This implementation differs from FIG. 13A in that the NAND gate 1310 receives PPH<3:0> on the first input path 1311, the NOR gate 1320 receives NPH<3:0> on the first input path 1321, and the path 1341 carries the real average duty cycle, drv_dc_sns. There is a low-pass filter (RC circuit) attached to the drv_dc_sns to generate the average signal of it.

Generally, the NPH/PPH duty cycle defines the activity time of the driver slice. When the pulse width of the PPH(NPH) is too short, there might be a time interval when all four slices are disabled. The effective output impedance in this case increases. On the other hand, when the pulse width is too long, there could be more than two slices activated simultaneously, decreasing the effective output impedance. Thus, there is a certain pulse width for which the output impedance exactly matches that of a constantly enabled single slice.

The duty cycle sensor can determine a duty cycle of one clock signal at a time, in one approach. The sensor can communicate the results to the digital control 936 for use in adjusting the timing of the phase generator 924.

In FIG. 13A and 13B, d_dc is a voltage that defines whether the high-side or the low-side is measured. The high-side refers to measuring PPH<3:0> and the low-side refers to measuring NPH<3:0>. The circuit of FIG. 13A, having a constantly enabled slice, generates the target value, drv_dc_tgt, while the circuit of FIG. 13B, driven by NPH/PPH, measures the real average duty cycle, drv_dc_sns. The average duty cycle can be increased or decreased based on the comparison of the two values. To achieve the increase or decrease, the average duty cycle sensor 952 communicates with the digital control 936 which in turn communicates with the phase generator 924 in FIG. 9.

SLC 8 LSB refers to 8 least significant bits (LSBs) strength of this replica compared to 128 LSBs (7 Bits DAC) of the whole driver.

Note that FIG. 13A and 13B provide two separate circuits which have the same construction but different inputs and outputs.

FIG. 14A depicts an example plot of the target and sensed output voltages of the positive phase (PPH) average duty cycle sensor 952 of FIG. 13B versus delta pulse width (Δw), in accordance with various embodiments.

FIG. 14B depicts an example plot of the target and sensed output voltage of the negative phase (NPH) average duty cycle sensor 952 of FIG. 13B versus delta pulse width (Δw), in accordance with various embodiments.

These figures show the output voltage of the duty cycle sensor for a delta pulse width range between 1U-1ps and 1UI+1ps, where 1UI=17.2ps at 116 Gbps data rate transmission, for example. The optimal or otherwise preferred or desirable pulse width can be determined at the point 1400 or 1410 where the two lines intersect, where the constant, solid line represents drv_dc_tgt and the changing, the dashed line represents drv_dc_sns. In one approach, the duty cycle sensor is to determine the optimal pulse width delta as a pulse width delta at which a measured duty cycle corresponds to the target duty cycle.

In FIG. 14A, in the case of PPH duty-cycle calibration, the optimal delta pulse width is UI+0.75pSec as denoted by the dotted arrow, where Δw_opt is determined to be +0.75pSec.

In FIG. 14B, in the case of NPH duty-cycle calibration, the optimal pulse width is 3UI-0.25pSec as denoted by the dotted arrow, where Δw_opt is determined to be -0.25pSec.

In either case, the "narrow" part of the pulse is getting wider.

FIG. 15 depicts an example implementation of the phase detector 950 of FIG. 9, in accordance with various embodiments. The phase detector includes four paths that receive the four data signals on path 913 from the HF PISO (FIG. 9), and output data to a 4:1 multiplexer 1550. A first path 1510 includes a power supply node 1511 and pMOS transistors 1512, 1513, and 1514 with control gate voltages of NPH<0>, D0, and D2, respectively, to output a bit Y0 on a path 1515 to the mux. 1550. A second path 1520 includes a power supply node 1521 and pMOS transistors 1522, 1523, and 1524 with control gate voltages of NPH<1>, D0, and D2, respectively, to output a bit Y1 on a path 1525 to the mux. A third path 1530 includes a power supply node 1531 and pMOS transistors 1532, 1533, and 1534 with control gate voltages of NPH<2>, D0, and D2, respectively, to output a bit Y2 on a path 1535 to the mux. A fourth path 1540 includes a power supply node 1541 and pMOS transistors 1542, 1543, and 1544 with control gate voltages of NPH<3>, D0, and D2, respectively, to output a bit Y3 on a path 1545 to the mux. Each path is an open-drain NOR gate.

As explained above, the driver phases (NPH/PPH) are not correlated to the 8-UI driving HF PISO 908. Hence, to provide proper data alignment, the phase detector can be used to read the skew between the data and the NPH/PPH clocks inside the driver. The phase detector includes four open-drain NOR gates (NPH[3:0]+D0+D2) connected to a resistive load (resistor 1551) through the 4:1 mux. 1550. The output voltage is averaged by an RC-filter comprising a resistor 1552 and a capacitor 1553, to provide an output PD<i> on a path 1554, where i=0,1,2,3. PD<0>, PD<1>, PD<2> and PD<3> denotes phase differences for the paths 1510, 1520, 1530, and 1540, respectively. Note that D0 and D2 are two of four bits that are received by the phase detector 950 on path 913.

FIG. 16 depicts an example timing diagram consistent with the phase detector 950 of FIG. 15, in accordance with various embodiments. Waveforms 1600, 1610, 1620, and 1630 depict the NPH clock signals N0, N1, N2, and N3, respectively. N0 transitions low at t3-t4, t7-t8 and t11-t12. N1 transitions low at t0-t1, t4-t5 and t8-t9. N2 transitions low at t1-t2, t5-t6 and t9-t10. N3 transitions low at t2-t3, t6-t7 and t10-t11. Waveforms 1640 and 1650 depict D2 and D0, respectively. Waveforms 1660, 1670, 1680 and 1690 depict Y0, Y1, Y2, and Y3, respectively.

The HF PISO obtains the sequence (01011010b from DIG 903 block. These are input logic bits that are provided from the digital controller (936) to the input of the HF PISO. The bits D0 and D2 are the 8-UI clock patterns derived from the HF PISO on path 913, and N0-N3 are the NPH set (i.e., N0=NPH<0>, N1=NPH<1>, N2=NPH<2> and N3=NPH<3>). When the transitions of D[0,2] are aligned with the rising edge of N1 and N3 respectively, averaged outputs Y0 and Y2 are equal (PD0=PD2). Note, that transitions of D0 and D2 matching N1 and N3 rising edges means that flat or stable periods of D0 and D2 match N0 and N2, i.e. the data is properly aligned. For example, the arrows extending from the low transitions of N0 to D0 occur at times which are midpoints of flat periods of D0 ( in this example, 1.5UI difference between the falling edge D0 to the falling edge of N0 and 1.5UI from the rising edge of N0 to the rising edge of D0), e.g., between t3 and t4, where the flat period is at t2-t5, and between t7 and t8, where the flat period is at t6-t7. Also, the arrows extending from the low transitions of N2 to D2 occur at times which are midpoints of flat periods of D2, e.g., between t1 and t2, where the flat period is at t0-t3, between t5 and t6, where the flat period is at t4-t7, and between t7 and t8, where the flat period is at t6-t9.

Consider the case where the data is misaligned. For example, suppose D0 and D2 transitions move left as shown by dotted lines 1641, 1643, 1651, and 1653 compared to solid lines 1642, 1644, 1652, and 1654, respectively. Then, Y0 will be longer, as represented by the dotted line 1661 compared to the solid line 1662, and Y2 becomes shorter, as represented by the dotted line 1681 compared to the solid line 1682. As a result, PD0 > PD2. Symmetrically, moving D0 and D2 to the right will yield PD0 < PD2.

Forcing PD0=PD2 is not enough, as it may also occur if D0 and D2 match N2 and N0. To eliminate this condition, one also must make sure that PD1>PD3. Both conditions upheld together (PD1 > PD3 and PD2 == PD0) result in a good alignment, namely the NPH and PPH sample the data where setup and hold times between the HF PISO and the driver is about 1.5 UI.

A similar diagram can be provided which applies to PPH clock signals but with replacing with nMOS devices in FIG. 15 and attaching into ground instead of a power supply so that the effective logic gate in the NAND is between the PPH clock signals and D0 and D2 instead of in a NOR between NPH clock signals with D0 and D2.

FIG. 17 illustrates an example of components that may be present in a computing system 1750 for implementing the techniques (e.g., operations, processes, methods, and methodologies) described herein.

The transmitter 900 of FIG. 9 may communicate with one or more other components in the computing system or outside the computing system to provide data signals. Communications outside the computing system may pass through the interface circuitry 1770 to the external devices 1772.

A power source 1700 such as a voltage converter may provide power to one or more of the components of the computing system 1750.

The memory circuitry 1754 may store instructions and the processor circuitry 1752 may execute the instructions to perform the functions described herein.

The computing system 1750 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1750, or as components otherwise incorporated within a chassis of a larger system. For one embodiment, at least one processor 1752 may be packaged together with computational logic 1782 and configured to practice aspects of various example embodiments described herein to form a System in Package (SiP) or a System on Chip (SoC).

System 1750 includes processor circuitry in the form of one or more processors 1752. The processor circuitry 1752 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1752 may include one or more hardware accelerators (e.g., same or similar to acceleration circuitry 1764), which may be microprocessors, programmable processing devices (e.g., FPGA, ASIC, etc.), or the like. One or more accelerators may include, for example, computer vision and/or deep learning accelerators. In some implementations, the processor circuitry 1752 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1752 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1752 may be coupled with or may include memory/storage and may be configured to execute instructions stored in the memory/storage to enable various applications or operating systems to run on platform 1750. The processors (or cores) 1752 are configured to operate application software to provide a specific service to a user of the platform 1750. In some embodiments, the processor(s) 1752 may be a special-purpose processor(s)/controller(s) configured (or configurable) to operate according to the various embodiments herein.

As examples, the processor(s) 1752 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1752 may be a part of a system on a chip (SoC), System-in-Package (SiP), a multi-chip package (MCP), and/or the like, in which the processor(s) 1752 and other components are formed into a single integrated circuit, or a single package, such as the Edison^{™} or Galileo^{™} SoC boards from Intel^{®} Corporation. Other examples of the processor(s) 1752 are mentioned elsewhere in the present disclosure.

The system 1750 may include or be coupled to acceleration circuitry 1764, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1764 may comprise logic blocks or logic fabric and other interconnected resources that may be programmed (configured) to perform various functions, such as the procedures, methods, functions, etc. of the various embodiments discussed herein. In such implementations, the acceleration circuitry 1764 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1752 and/or acceleration circuitry 1764 may include hardware elements specifically tailored for machine learning and/or artificial intelligence (AI) functionality. In these implementations, the processor circuitry 1752 and/or acceleration circuitry 1764 may be, or may include an AI engine chip that can run many different kinds of AI instruction sets once loaded with the appropriate weightings and training code. Additionally, or alternatively, the processor circuitry 1752 and/or acceleration circuitry 1764 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1752 and/or acceleration circuitry 1764 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 1750 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bitstream (s), etc. to perform their respective functions.

System 1750 also includes system memory 1754. Any number of memory devices may be used to provide for a given amount of system memory. As example, the memory 1754 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1754 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1754 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1758 provides persistent storage of information such as data, applications, operating systems and so forth. In an example, the storage 1758 may be implemented via a solid-state disk drive (SSDD) and/or high-speed electrically erasable memory (commonly referred to as "flash memory"). Other devices that may be used for the storage 1758 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1754 and/or storage circuitry 1758 may also incorporate three-dimensional (3D) cross-point (XPOINT) memories from Intel^{®} and Micron^{®}.

The memory circuitry 1754 and/or storage circuitry 1758 is/are configured to store computational logic 1783 in the form of software, firmware, microcode, or hardware-level instructions to implement the techniques described herein. The computational logic 1783 may be employed to store working copies and/or permanent copies of programming instructions, or data to create the programming instructions, for the operation of various components of system 1750 (e.g., drivers, libraries, application programming interfaces (APIs), etc.), an operating system of system 1750, one or more applications, and/or for carrying out the embodiments discussed herein. The computational logic 1783 may be stored or loaded into memory circuitry 1754 as instructions 1782, or data to create the instructions 1782, which are then accessed for execution by the processor circuitry 1752 to carry out the functions described herein. The processor circuitry 1752 and/or the acceleration circuitry 1764 accesses the memory circuitry 1754 and/or the storage circuitry 1758 over the interconnect (IX) 1756. The instructions 1782 direct the processor circuitry 1752 to perform a specific sequence or flow of actions, for example, as described with respect to the flowchart(s) and block diagram(s) of operations and functionality depicted previously. The various elements may be implemented by assembler instructions supported by processor circuitry 1752 or high-level languages that may be compiled into instructions 1788, or data to create the instructions 1788, to be executed by the processor circuitry 1752. The permanent copy of the programming instructions may be placed into persistent storage devices of storage circuitry 1758 in the factory or in the field through, for example, a distribution medium (not shown), through a communication interface (e.g., from a distribution server (not shown)), over-the-air (OTA), or any combination thereof.

The IX 1756 couples the processor 1752 to communication circuitry 1766 for communications with other devices, such as a remote server (not shown) and the like. The communication circuitry 1766 is a hardware element, or collection of hardware elements, used to communicate over one or more networks 1763 and/or with other devices. In one example, communication circuitry 1766 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally, or alternatively, communication circuitry 1766 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1756 also couples the processor 1752 to interface circuitry 1770 that is used to connect system 1750 with one or more external devices 1772. The external devices 1772 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1750, which are referred to as input circuitry 1786 and output circuitry 1784. The input circuitry 1786 and output circuitry 1784 include one or more user interfaces designed to enable user interaction with the platform 1750 and/or peripheral component interfaces designed to enable peripheral component interaction with the platform 1750. Input circuitry 1786 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1784 may be included to show information or otherwise convey information, such as sensor readings, actuator position(s), or other like information. Data and/or graphics may be displayed on one or more user interface components of the output circuitry 1784. Output circuitry 1784 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1750. The output circuitry 1784 may also include speakers and/or other audio emitting devices, printer(s), and/or the like. Additionally or alternatively, sensor(s) may be used as the input circuitry 1784 (e.g., an image capture device, motion capture device, or the like) and one or more actuators may be used as the output device circuitry 1784 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1750 may communicate over the IX 1756. The IX 1756 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1756 may be a proprietary bus, for example, used in a SoC based system.

The number, capability, and/or capacity of the elements of system 1750 may vary, depending on whether computing system 1750 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 1750 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read-only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments, that are not within the scope of the invention, are presented below.

Example 1 includes an apparatus, comprising: a data path; a clock path; a digital control coupled to the data path and the clock path; and a driver coupled to the data path, the clock path and the digital control, wherein the driver comprises a phase detector to detect a phase error in data signals from the data path, the driver is to transmit the phase error to the digital control and the digital control is to adjust a timing of the data path based on the phase error.

Example 2 includes the apparatus of Example 1, wherein to adjust the timing of the data path based on the phase error, the digital control is to adjust a timing of a clock multiplexer which distributes clock signals from the clock path to the data path.

Example 3 includes the apparatus of Example 2, wherein: the data path comprises a digital data source, a low-frequency parallel-in, serial out (PISO) circuit coupled to the digital data source, and a high-frequency PISO circuit coupled to the low-frequency PISO circuit; and
the clock multiplexer is to distribute the clock signals from the clock path to the low-frequency PISO circuit and the high-frequency PISO circuit.

Example 4 includes the apparatus of any one of Examples 1-3, wherein: the driver comprises a duty cycle sensor to determine a target duty cycle and averaged measured duty cycles, to determine a pulse width delta based on the target duty cycle and the averaged measured duty cycles, and to transmit the pulse width delta to the digital control; and the digital control is to adjust a timing of a phase generator in the clock path based on the pulse width delta.

Example 5 includes the apparatus of any one of Examples 1-4, further comprising a quadrature sampler coupled to an output of a quadrature generator in the clock path in the clock path, wherein the quadrature sampler is to determine phase and duty cycle errors of clock signals output from the quadrature generator and to transmit the phase and duty cycle errors to the digital control, wherein the digital control is to adjust a timing of the quadrature generator based on the phase and duty cycle errors.

Example 6 includes the apparatus of any one of Examples 1-5, further comprising a phase sampler in the clock path, wherein the phase sampler is to determine phase and duty cycle errors of clock signals in the clock path and to transmit the phase and duty cycle errors to the digital control, and the digital control is to adjust a timing of a phase generator in the clock path based on the phase and duty cycle errors.

Example 7 includes the apparatus of Example 6, wherein: the phase sampler comprises multiplexers which receive the clocks signals as inputs; and outputs of the multiplexers are coupled to a plurality of sensors which are to determine phase and duty cycle errors of the clock signals.

Example 8 includes the apparatus of Example 7, wherein the plurality of sensors comprise a sensor to determine the phase error of the clock signals based on at least one of a rising edge-to-rising edge comparison or a falling edge-to-falling edge comparison.

Example 9 includes the apparatus of Example 7 or 8, wherein the plurality of sensors comprise a sensor to determine the phase error of the clock signals based on a positive to negative comparison.

Example 10 includes the apparatus of any one of Examples 7-9, wherein: each of the multiplexers comprises a set of segments; each segment comprises a bootstrapped n-type metal oxide silicon field effect transistor (nMOSFET); a drain of the nMOSFET is coupled to an input path for one of the clock signals; and a source of the nMOSFET is coupled to an output path.

Example 11 includes the apparatus of any one of Examples 1-10, further comprising at least one of a transmitter circuit, an integrated circuit, a System on Chip, a System in Package or a computing device in which the data path, the clock path, the digital control and the driver are provided.

Example 12 includes an apparatus, comprising: an input node to receive data signals from a data path and clock signals from a clock path; a phase detector to detect a phase error in the data signals, and to transmit the phase error to a digital control; a duty cycle sensor to determine a target duty cycle and averaged measured duty cycles, to determine a pulse width delta based on the target duty cycle and the averaged measured duty cycles, and to transmit the pulse width delta to the digital control; and an output node to transmit an analog multi-level signal based on the data signals and clock signals.

Example 13 includes the apparatus of Example 12, wherein the digital control is to adjust a timing of a phase generator in the clock path based on the pulse width delta.

Example 14 includes the apparatus of Example 12 or 13, wherein the digital control is to adjust a timing of the data path based on the phase error.

Example 15 includes the apparatus of any one of Examples 12-14, wherein the duty cycle sensor is to determine the pulse width delta as a pulse width delta at which a measured duty cycle corresponds to the target duty cycle.

Example 16 includes an apparatus, comprising: a set of multiplexers to receive clock signals from a clock path in a transmitter, wherein the clock signals are to be generated by a phase generator; a set of phase sensors coupled to outputs of the set of multiplexers, wherein the phase sensors are to determine phase errors of the clock signals; and an output multiplexer coupled to outputs of the phase sensors, wherein the output multiplexer is to provide the phase errors to a digital control, and the digital control is to adjust a timing of the phase generator based on the phase errors.

Example 17 includes the apparatus of Example 16, wherein: each of the multiplexers of the set of multiplexers comprises a set of segments; and each segment comprises a bootstrapped n-type metal oxide silicon field effect transistor (nMOSFET) coupled to an input path for one of the clock signals and an output path.

Example 18 includes the apparatus of Example 17, wherein: each segment comprises a first switch to couple a path comprising a capacitor to the input path and a second switch to couple a power supply node or ground to a control gate path of the nMOSFET and to the path comprising the capacitor.

Example 19 includes the apparatus of any one of Examples 16-18, wherein: the clock signals comprise positive phase clock signals and negative phase clock signals; and the set of phase sensors comprise a sensor to determine a phase error of the positive phase clock signals based on a rising edge-to-rising edge comparison, and a sensor to determine a phase error of the negative phase clock signals based on a falling edge-to-falling edge comparison.

Example 20 includes the apparatus of Example 19, wherein the set of phase sensors comprise a sensor to determine a positive to negative comparison of the negative phase clock signals.

Example 21 includes a method, comprising: detecting a phase error in data signals from a data path; transmitting the phase error to a digital control, wherein the digital control is coupled to the data path and the clock path; and at the digital control, adjusting a timing of the data path based on the phase error.

Example 22 includes the method of Example 21, wherein the adjusting the timing of the data path based on the phase error comprises adjusting a timing of a clock multiplexer which distributes clock signals from the clock path to the data path.

Example 23 includes the method of Example 22, further comprising distributing the clock signals from the clock path to a low-frequency PISO circuit and a high-frequency PISO circuit in the data path.

Example 24 includes the method of any one of Examples 21-23, further comprising: determining a target duty cycle and averaged measured duty cycles, to determine a pulse width delta; transmitting the pulse width delta to the digital control; and adjusting a timing of a phase generator in the clock path based on the pulse width delta.

Example 25 includes the method of any one of Examples 21-24, further comprising: determining a phase error of clock signals output from a quadrature generator; transmitting the phase error to the digital control; and at the digital control, adjusting a timing of the quadrature generator based on the phase error.

Example 26 includes the method of any one of Examples 21-25, further comprising: determining a phase error of clock signals in the clock path; transmitting the phase error to the digital control; and at the digital control, adjusting a timing of a phase generator in the clock path based on the phase error.

Example 27 includes the method of Example 27 or 28, further comprising determine the phase error of the clock signals based on a falling edge-to-falling edge comparison.

Example 28 includes the method of Example 27 or 28, further comprising determine the phase error of the clock signals based on a positive to negative comparison.

Example 29 includes a non-transitory machine-readable storage including machine-readable instructions that, when executed, cause a processor or other circuit or computing device to implement the method of any one of Examples 21-28.

Example 30 includes a computer program comprising instructions which, when the program is executed by a computer, cause the computer to carry out the method of any one of Examples 21 to 23.

Example 31 includes a method, comprising: at a set of multiplexers, receiving clock signals from a clock path in a transmitter, wherein the clock signals are to be generated by a phase generator; at a set of phase sensors coupled to outputs of the set of multiplexers, determining phase errors of the clock signals; at an output multiplexer coupled to outputs of the phase sensors, providing the phase errors to a digital control; and at the digital control, adjusting a timing of the phase generator based on the phase errors.

Example 32 includes the method of Example 31, further comprising: coupling a path comprising a capacitor to the input path; and coupling a power supply node or ground to a control gate path of the nMOSFET and to the path comprising the capacitor.

Example 33 includes a non-transitory machine-readable storage including machine-readable instructions that, when executed, cause a processor or other circuit or computing device to implement the method of Example 31 or 32.

Example 34 includes a computer program comprising instructions which, when the program is executed by a computer, cause the computer to carry out the method of Example 31 or 32.

In the present detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a data path (625) comprising a digital data source, a low-frequency parallel-in, serial out, PISO, circuit and a high-frequency PISO circuit coupled to the low-frequency PISO circuit;
a clock path (610, 960);
a digital control (936) coupled to the data path (625) and the clock path (610, 960);
a clock multiplexer (911) configured to receive clock signals from the clock path (610, 960) and to distribute the clock signals from the clock path (610, 960) to the low-frequency PISO circuit and the high-frequency PISO circuit; and
a driver (425, 951) coupled to the data path (625), the clock path (610, 960), and the digital control (936),
wherein the driver (425, 951) comprises a phase detector (950) coupled to the high-frequency PISO circuit of the data path and configured to detect a phase error between data signals of the data path (625) and clock signals of the clock path (610, 960),
wherein the driver (425, 951) is configured to transmit the phase error to the digital control (936), and the digital control (936) is configured to adjust a timing of the clock multiplexer (911) based on the phase error.

2. The apparatus of claim 1, wherein:
the driver (425, 951) comprises a duty cycle sensor to determine a target duty cycle and averaged measured duty cycles, to determine a pulse width delta based on the target duty cycle and the averaged measured duty cycles, and to transmit the pulse width delta to the digital control (936); and
the digital control (936) is to adjust a timing of a phase generator (924) in the clock path (610, 960) based on the pulse width delta.

3. The apparatus of any one of claims 1-2, further comprising a quadrature sampler coupled to an output of a quadrature generator (922) in the clock path (610, 960) in the clock path (610, 960), wherein the quadrature sampler is to determine phase and duty cycle errors of clock signals output from the quadrature generator (922) and to transmit the phase and duty cycle errors to the digital control (936), wherein the digital control (936) is to adjust a timing of the quadrature generator (922) based on the phase and duty cycle errors.

4. The apparatus of any one of claims 1-3, further comprising a phase sampler (940) in the clock path (610, 960), wherein the phase sampler (940) is to determine phase and duty cycle errors of clock signals in the clock path (610, 960) and to transmit the phase and duty cycle errors to the digital control (936), and the digital control (936) is to adjust a timing of a phase generator (924) in the clock path (610, 960) based on the phase and duty cycle errors.

5. The apparatus of claim 4, wherein:
the phase sampler (940) comprises multiplexers which receive the clocks signals as inputs; and
outputs of the multiplexers are coupled to a plurality of sensors which are to determine a phase error of the clock signals.

6. The apparatus of claim 5, wherein the plurality of sensors comprise a sensor to determine the phase and duty cycle errors of the clock signals based on at least one of a rising edge-to-rising edge comparison or a falling edge-to-falling edge comparison.

7. The apparatus of claim 5 or 6, wherein the sensors comprise a sensor to determine the phase error of the clock signals based on a positive to negative comparison.

8. The apparatus of any one of claims 5-7, wherein:
each of the multiplexers comprises a set of segments;
each segment comprises a bootstrapped n-type metal oxide silicon field effect transistor, nMOSFET;
a drain of the nMOSFET is coupled to an input path for one of the clock signals; and
a source of the nMOSFET is coupled to an output path.

9. The apparatus of any one of claims 1-8, further comprising at least one of a transmitter (900) circuit, an integrated circuit, a System on Chip, a System in Package or a computing device in which the data path (625), the clock path (610, 960), the digital control (936) and the driver (425, 951) are provided.

10. A non-transitory machine-readable storage including machine-readable instructions that, when executed, cause a processor or other circuit or computing device to perform a method comprising:
detecting a phase error between data signals of a data path (625) and clock signals of a clock path (610, 960); the data path comprising a low-frequency PISO and a high-frequency PISO signal and the data signals obtained from the high-frequency PISO;
transmitting the phase error to a digital control (936), wherein the digital control (936) is coupled to the data path (625) and the clock path (610, 960);
at the digital control (936), adjusting a timing of the data path (625) based on the phase error, wherein the adjusting the timing of the data path (625) based on the phase error comprises adjusting a timing of a clock multiplexer (911) which distributes clock signals from the clock path (610, 960) to the data path (625); and
distributing the clock signals from the clock path (610, 960) to the low-frequency PISO circuit and the high-frequency PISO circuit in the data path (625).

11. The non-transitory machine-readable storage of claim 10, wherein the method performed further comprises:
determining a target duty cycle and averaged measured duty cycles, to determine a pulse width delta;
transmitting the pulse width delta to the digital control (936); and
adjusting a timing of a phase generator (924) in the clock path (610, 960) based on the pulse width delta.

12. The non-transitory machine-readable storage of claim 10 or 11, wherein the method performed further comprises:
determining a phase error of clock signals output from a quadrature generator (922);
transmitting the phase error to the digital control (936); and
at the digital control (936), adjusting a timing of the quadrature generator (922) based on the phase error.

13. The non-transitory machine-readable storage of any one of claims 10-12, wherein the method performed further comprises:
determining a phase error of the clock signals in the clock path (610, 960);
transmitting the phase error to the digital control (936); and
at the digital control (936), adjusting a timing of a phase generator (924) in the clock path (610, 960) based on the phase error of the clock signals, wherein the phase error of the clock signals is determined based on a falling edge-to-falling edge comparison or based on a positive to negative comparison.

## Patentansprüche

1. Einrichtung, umfassend:
einen Datenpfad (625), der eine digitale Datenquelle, eine Niederfrequenz-Parallel-In, Serial-Out- bzw. -PISO-Schaltung und eine Hochfrequenz-PISO-Schaltung, die mit der Niederfrequenz-PISO-Schaltung gekoppelt ist, umfasst;
einen Taktpfad (610, 960);
eine digitale Steuerung (936), die mit dem Datenpfad (625) und dem Taktpfad (610, 960) gekoppelt ist;
einen Taktmultiplexer (911), der dazu ausgelegt ist, Taktsignale von dem Taktpfad (610, 960) zu empfangen und die Taktsignale von dem Taktpfad (610, 960) an die Niederfrequenz-PISO-Schaltung und die Hochfrequenz-PISO-Schaltung zu verteilen; und
einen Treiber (425, 951), der mit dem Datenpfad (625), dem Taktpfad (610, 960) und der digitalen Steuerung (936) gekoppelt ist,
wobei der Treiber (425, 951) einen Phasendetektor (950) umfasst, der mit der Hochfrequenz-PISO-Schaltung des Datenpfads gekoppelt ist und dazu ausgelegt ist, einen Phasenfehler zwischen Datensignalen des Datenpfads (625) und Taktsignalen des Taktpfads (610, 960) zu detektieren, wobei der Treiber (425, 951) dazu ausgelegt ist, den Phasenfehler an die digitale Steuerung (936) zu übertragen, und die digitale Steuerung (936) dazu ausgelegt ist, ein Timing des Taktmultiplexers (911) basierend auf dem Phasenfehler anzupassen.

2. Einrichtung nach Anspruch 1, wobei:
der Treiber (425, 951) einen Tastverhältnissensor zum Bestimmen eines Zieltastverhältnisses und gemittelter gemessener Tastverhältnisse, zum Bestimmen eines Pulsbreitendeltas basierend auf dem Zieltastverhältnis und den gemittelten gemessenen Tastverhältnissen und zum Übertragen des Pulsbreitendeltas an die digitale Steuerung (936) umfasst; und
die digitale Steuerung (936) zum Anpassen eines Timings eines Phasengenerators (924) in dem Taktpfad (610, 960) basierend auf dem Pulsbreitendelta dient.

3. Einrichtung nach einem der Ansprüche 1-2, ferner umfassend einen Quadraturabtaster, der mit einem Ausgang eines Quadraturgenerators (922) in dem Taktpfad (610, 960) in dem Taktpfad (610, 960) gekoppelt ist, wobei der Quadraturabtaster Phasen- und Tastverhältnisfehler von Taktsignalen, die von dem Quadraturgenerator (922) ausgegeben werden, bestimmen und die Phasen- und Tastverhältnisfehler an die digitale Steuerung (936) übertragen soll, wobei die digitale Steuerung (936) ein Timing des Quadraturgenerators (922) basierend auf den Phasen- und Tastverhältnisfehlern anpassen soll.

4. Einrichtung nach einem der Ansprüche 1-3, ferner umfassend einen Phasenabtaster (940) in dem Taktpfad (610, 960), wobei der Phasenabtaster (940) Phasen- und Tastverhältnisfehler von Taktsignalen in dem Taktpfad (610, 960) bestimmen und die Phasen- und Tastverhältnisfehler an die digitale Steuerung (936) übertragen soll, und die digitale Steuerung (936) ein Timing eines Phasengenerators (924) in dem Taktpfad (610, 960) basierend auf den Phasen- und Tastverhältnisfehlern anpassen soll.

5. Einrichtung nach Anspruch 4, wobei:
der Phasenabtaster (940) Multiplexer umfasst, die die Taktsignale als Eingänge empfangen; und
Ausgänge der Multiplexer mit einer Mehrzahl von Sensoren gekoppelt sind, die einen Phasenfehler der Taktsignale bestimmen sollen.

6. Einrichtung nach Anspruch 5, wobei die Mehrzahl von Sensoren einen Sensor zum Bestimmen der Phasen- und Tastverhältnisfehler der Taktsignale basierend auf einem Vergleich von steigender Flanke zu steigender Flanke und/oder einem Vergleich von fallender Flanke zu fallender Flanke umfassen.

7. Einrichtung nach Anspruch 5 oder 6, wobei die Sensoren einen Sensor zum Bestimmen des Phasenfehlers der Taktsignale basierend auf einem Positiv-Negativ-Vergleich umfassen.

8. Einrichtung nach einem der Ansprüche 5-7, wobei:
jeder der Multiplexer einen Satz von Segmenten umfasst;
jedes Segment einen Bootstrap-n-Typ-Metalloxid-Silizium-Feldeffekttransistor, nMOSFET, umfasst;
ein Drain des nMOSFET mit einem Eingangspfad für eines der Taktsignale gekoppelt ist; und
eine Source des nMOSFET mit einem Ausgangspfad gekoppelt ist.

9. Einrichtung nach einem der Ansprüche 1-8, ferner umfassend mindestens eines von einer Senderschaltung (900), einer integrierten Schaltung, einem System-on-Chip, einem System-in-Package oder einer Rechenvorrichtung, in der bzw. dem der Datenpfad (625), der Taktpfad (610, 960), die digitale Steuerung (936) und der Treiber (425, 951) bereitgestellt sind.

10. Nichtflüchtige maschinenlesbare Speicherung, die maschinenlesbare Anweisungen aufweist, die bei Ausführung einen Prozessor oder eine andere Schaltung veranlassen, ein Verfahren durchzuführen, das umfasst:
Detektieren eines Phasenfehlers zwischen Datensignalen eines Datenpfads (625) und Taktsignalen eines Taktpfads (610, 960); wobei der Datenpfad ein Niederfrequenz-PISO- und ein Hochfrequenz-PISO-Signal umfasst und die Datensignale von dem Hochfrequenz-PISO erhalten werden;
Übertragen des Phasenfehlers an eine digitale Steuerung (936), wobei die digitale Steuerung (936) mit dem Datenpfad (625) und dem Taktpfad (610, 960) gekoppelt ist;
an der digitalen Steuerung (936), Anpassen eines Timings des Datenpfads (625) basierend auf dem Phasenfehler, wobei das Anpassen des Timings des Datenpfads (625) basierend auf dem Phasenfehler das Anpassen eines Timings eines Taktmultiplexers (911), der Taktsignale von dem Taktpfad (610, 960) an den Datenpfad (625) verteilt, umfasst; und
Verteilen der Taktsignale von dem Taktpfad (610, 960) an die Niederfrequenz-PISO-Schaltung und die Hochfrequenz-PISO-Schaltung in dem Datenpfad (625).

11. Nichtflüchtige maschinenlesbare Speicherung nach Anspruch 10, wobei das durchgeführte Verfahren ferner umfasst:
Bestimmen eines Zieltastverhältnisses und gemittelter gemessener Tastverhältnisse, um ein Pulsbreitendelta zu bestimmen;
Übertragen des Pulsbreitendeltas an die digitale Steuerung (936); und
Anpassen eines Timings eines Phasengenerators (924) in dem Taktpfad (610, 960) basierend auf dem Pulsbreitendelta.

12. Nichtflüchtige maschinenlesbare Speicherung nach Anspruch 10 oder 11, wobei das durchgeführte Verfahren ferner umfasst:
Bestimmen eines Phasenfehlers von Taktsignalen, die von einem Quadraturgenerator (922) ausgegeben werden;
Übertragen des Phasenfehlers an die digitale Steuerung (936); und
an der digitalen Steuerung (936), Anpassen eines Timings des Quadraturgenerators (922) basierend auf dem Phasenfehler.

13. Nichtflüchtige maschinenlesbare Speicherung nach einem der Ansprüche 10-12, wobei das durchgeführte Verfahren ferner umfasst:
Bestimmen eines Phasenfehlers der Taktsignale in dem Taktpfad (610, 960);
Übertragen des Phasenfehlers an die digitale Steuerung (936); und
an der digitalen Steuerung (936), Anpassen eines Timings eines Phasengenerators (924) in dem Taktpfad (610, 960) basierend auf dem Phasenfehler der Taktsignale, wobei der Phasenfehler der Taktsignale basierend auf einem Vergleich von fallender Flanke zu fallender Flanke oder basierend auf einem Positiv-Negativ-Vergleich bestimmt wird.

## Revendications

1. Appareil, comprenant :
un chemin de données (625) comprenant une source de données numériques, un circuit parallèle en entrée, série en sortie (PISO) à basse fréquence et un circuit PISO à haute fréquence couplé au circuit PISO à basse fréquence ;
un chemin d'horloge (610, 960) ;
une commande numérique (936) couplée au chemin de données (625) et au chemin d'horloge (610, 960) ;
un multiplexeur d'horloge (911) configuré pour recevoir des signaux d'horloge en provenance du chemin d'horloge (610, 960) et pour distribuer les signaux d'horloge en provenance du chemin d'horloge (610, 960) au circuit PISO à basse fréquence et au circuit PISO à haute fréquence ; et
un pilote (425, 951) couplé au chemin de données (625), au chemin d'horloge (610, 960) et à la commande numérique (936),
le pilote (425, 951) comprenant un détecteur de phase (950) couplé au circuit PISO à haute fréquence du chemin de données et configuré pour détecter une erreur de phase entre des signaux de données du chemin de données (625) et des signaux d'horloge du chemin d'horloge (610, 960),
le pilote (425, 951) étant configuré pour transmettre l'erreur de phase à la commande numérique (936), et la commande numérique (936) étant configurée pour régler une temporisation du multiplexeur d'horloge (911) sur la base de l'erreur de phase.

2. Appareil selon la revendication 1,
le pilote (425, 951) comprenant un capteur de cycle de service pour déterminer un cycle de service cible et des cycles de service mesurés moyens, pour déterminer une différence de largeur d'impulsion sur la base du cycle de service cible et des cycles de service mesurés moyens, et pour transmettre la différence de largeur d'impulsion à la commande numérique (936) ; et
la commande numérique (936) sert à régler une temporisation d'un générateur de phase (924) dans le chemin d'horloge (610, 960) sur la base de la différence de largeur d'impulsion.

3. Appareil selon l'une quelconque des revendications 1 et 2, comprenant en outre un échantillonneur en quadrature couplé à une sortie d'un générateur en quadrature (922) dans le chemin d'horloge (610, 960) dans le chemin d'horloge (610, 960), l'échantillonneur en quadrature servant à déterminer des erreurs de phase et de cycle de service de signaux d'horloge délivrés en sortie par le générateur en quadrature (922) et à transmettre les erreurs de phase et de cycle de service à la commande numérique (936), la commande numérique (936) servant à régler une temporisation du générateur en quadrature (922) sur la base des erreurs de phase et de cycle de service.

4. Appareil selon l'une quelconque des revendications 1 à 3, comprenant en outre un échantillonneur de phase (940) dans le chemin d'horloge (610, 960), l'échantillonneur de phase (940) servant à déterminer des erreurs de phase et de cycle de service de signaux d'horloge dans le chemin d'horloge (610, 960) et à transmettre les erreurs de phase et de cycle de service à la commande numérique (936), et la commande numérique (936) servant à régler une temporisation d'un générateur de phase (924) dans le chemin d'horloge (610, 960) sur la base des erreurs de phase et de cycle de service.

5. Appareil selon la revendication 4,
l'échantillonneur de phase (940) comprenant des multiplexeurs qui reçoivent les signaux d'horloge en tant qu'entrées ; et
les sorties des multiplexeurs étant couplées à une pluralité de capteurs qui servent à déterminer une erreur de phase des signaux d'horloge.

6. Appareil selon la revendication 5, la pluralité de capteurs comprenant un capteur pour déterminer les erreurs de phase et de cycle de service des signaux d'horloge sur la base d'au moins une comparaison parmi une comparaison front montant-front montant et une comparaison front descendant-front descendant.

7. Appareil selon la revendication 5 ou 6, les capteurs comprenant un capteur pour déterminer l'erreur de phase des signaux d'horloge sur la base d'une comparaison positive-négative.

8. Appareil selon l'une quelconque des revendications 5 à 7,
chacun des multiplexeurs comprenant un ensemble de segments ;
chaque segment comprenant un transistor à effet de champ à semi-conducteur à oxyde métallique de type N (nMOSFET) amorcé ;
un drain du nMOSFET étant couplé à un chemin d'entrée pour l'un des signaux d'horloge ; et
une source du nMOSFET étant couplée à un chemin de sortie.

9. Appareil selon l'une quelconque des revendications 1 à 8, comprenant en outre au moins un élément parmi un circuit émetteur (900), un circuit intégré, un système en boîtier et un dispositif informatique où sont situés le chemin de données (625), le chemin d'horloge (610, 960), la commande numérique (936) et le pilote (425, 951).

10. Stockage non transitoire lisible par machine, comprenant des instructions lisibles par machine qui, lorsqu'elles sont exécutées, amènent un processeur ou un autre circuit ou dispositif informatique à réaliser un procédé comprenant les étapes consistant à :
détecter une erreur de phase entre des signaux de données d'un chemin de données (625) et des signaux d'horloge d'un chemin d'horloge (610, 960), le chemin de données comprenant un PISO à basse fréquence et un signal PISO à haute fréquence et les signaux de données obtenus à partir du PISO à haute fréquence ;
transmettre l'erreur de phase à une commande numérique (936), la commande numérique (936) étant couplée au chemin de données (625) et au chemin d'horloge (610, 960) ;
au niveau de la commande numérique (936), régler une temporisation du chemin de données (625) sur la base de l'erreur de phase, le réglage de la temporisation du chemin de données (625) sur la base de l'erreur de phase comprenant l'étape consistant à régler une temporisation d'un multiplexeur d'horloge (911) qui distribue des signaux d'horloge en provenance du chemin d'horloge (610, 960) au chemin de données (625) ; et
distribuer les signaux d'horloge en provenance du chemin d'horloge (610, 960) au circuit PISO à basse fréquence et au circuit PISO à haute fréquence dans le chemin de données (625).

11. Stockage non transitoire lisible par machine selon la revendication 10, le procédé réalisé comprenant en outre les étapes consistant à :
déterminer un cycle de service cible et des cycles de service mesurés moyens, afin de déterminer une différence de largeur d'impulsion ;
transmettre la différence de largeur d'impulsion à la commande numérique (936) ; et
régler une temporisation d'un générateur de phase (924) dans le chemin d'horloge (610, 960) sur la base de la différence de largeur d'impulsion.

12. Stockage non transitoire lisible par machine selon la revendication 10 ou 11, le procédé réalisé comprenant en outre les étapes consistant à :
déterminer une erreur de phase de signaux d'horloge délivrés en sortie par un générateur en quadrature (922) ;
transmettre l'erreur de phase à la commande numérique (936) ; et
au niveau de la commande numérique (936), régler une temporisation du générateur en quadrature (922) sur la base de l'erreur de phase.

13. Stockage non transitoire lisible par machine selon l'une quelconque des revendications 10 à 12, le procédé réalisé comprenant en outre les étapes consistant à :
déterminer une erreur de phase des signaux d'horloge dans le chemin d'horloge (610, 960) ;
transmettre l'erreur de phase à la commande numérique (936) ; et
au niveau de la commande numérique (936), régler une temporisation d'un générateur de phase (924) dans le chemin d'horloge (610, 960) sur la base de l'erreur de phase des signaux d'horloge, l'erreur de phase des signaux d'horloge étant déterminée sur la base d'une comparaison front descendant-front descendant ou sur la base d'une comparaison positive-négative.
